(19) Europäisches Patentamt
European Patent Office
Office européen des brevets

(11) Publication number: **0 347 936 A2**

(12) **EUROPEAN PATENT APPLICATION**

(21) Application number: 89111478.7

(51) Int. Cl.4: B29C 67/14 , B29C 43/48

(22) Date of filing: 23.06.89

(30) Priority: 24.06.88 JP 156548/88
25.08.88 JP 211045/88
22.09.88 JP 238114/88
06.10.88 JP 252658/88
25.11.88 JP 297404/88

(43) Date of publication of application:
27.12.89 Bulletin 89/52

(84) Designated Contracting States:
DE FR GB IT

(71) Applicant: SHOWA DENKO KABUSHIKI KAISHA
10-12, Shiba Daimon 2-chome Minato-ku
Tokyo(JP)

(72) Inventor: Matsuda, Atsuhiko
c/o Showa Denko Kabushiki Kaisha 3-2, Chidori-cho
Kawasaki-shi Kanagawa(JP)
Inventor: Noda, Satoshi
c/o Showa Denko Kabushiki Kaisha 3-2, Chidori-cho
Kawasaki-shi Kanagawa(JP)
Inventor: Toyoda, Yukio
c/o Showa Denko Kabushiki Kaisha 3-2, Chidori-cho
Kawasaki-shi Kanagawa(JP)
Inventor: Mimura, Norikazu
c/o Showa Denko Kabushiki Kaisha 3-2, Chidori-cho
Kawasaki-shi Kanagawa(JP)
Inventor: Suzuki, Noboru
c/o Showa Denko Kabushiki Kaisha 3-2, Chidori-cho
Kawasaki-shi Kanagawa(JP)
Inventor: Onoda, Takeshi
c/o Showa Denko Kabushiki Kaisha 3-2, Chidori-cho
Kawasaki-shi Kanagawa(JP)
Inventor: Matsunaga, Toyoharu
c/o Showa Denko Kabushiki Kaisha 3-2, Chidori-cho
Kawasaki-shi Kanagawa(JP)

(74) Representative: Henkel, Feiler, Hänzel & Partner
Möhlstrasse 37
D-8000 München 80(DE)

(54) **Continuous production of laminated sheet.**

(57) A method and apparatus is disclosed for continuously producing a laminated sheet comprising the steps of impregnating a fibrous base of continuous length with a thermosetting resin solution which neither essentially requires a drying step nor essentially produces reaction by-products during the curing reaction thereof and heat-pressing in which a plurality of the impregnated bases are layered and heat-pressed to cure the resin solution to provide an integral structure, wherein said impregnating step is carried out by partially impregnating the base with the resin solution and said heat-pressing step is carried out in such a manner that the resin solution penetrates throughout the bases by using a double belt press comprising endless belts, said press applying a substantially even pressure over the entire pressurizing zone.

EP 0 347 936 A2

# CONTINUOUS PRODUCTION OF LAMINATED SHEET

## FIELD OF THE INVENTION

This invention relates to a method for continuously producing a laminated sheet which is suitable particularly for electrical laminates and printed circuit boards.

## BACKGROUND OF THE INVENTION

Laminated sheets composed of a plurality of resin-impregnated fibrous bases with or without a metal foil as the outermost layer are widely used as electrical insulating laminates or printed circuit boards. The production of a large quantity of laminated sheet in an efficient manner is in demand.

This type of laminate has conventionally been produced by a batch pressing method comprising impregnating a fibrous base with a resin solution, drying and polymerizing the impregnated resin solution to an appropriate degree to form a prepreg, cutting the prepreg to a desired size, layering a desired number of the prepregs, and pressing the prepreg laminate to obtain a laminated sheet. However, since the prepregs are pressed only after being cut to size and layered, it was impossible to produce a laminated sheet in a continuous manner, thus resulting in a method of low productivity.

In order to solve this problem, a continuous method has been proposed, in which a resin solution is impregnated into a fibrous base of continuous length, dried and polymerized to an appropriate degree to form a prepreg of continuous length. A plurality of prepregs each in a roll form are thus prepared, and a plurality of prepregs are unrolled, layered, and pressed to obtain a continuous laminated sheet. According to this method, however, it is necessary to preliminarily prepare rolls of a prepreg, thus complicating the production process and requiring quality control of the prepreg rolls. Moreover, when using unsaturated resins which undergo curing through radical polymerization, such as unsaturated polyester resins, it is difficult to interrupt the curing reaction in a controlled manner, thereby resulting in prepreg rolls having variations in quality.

A method for continuously producing a laminated sheet in the substantial absence of applied pressure (contact laminating) has been developed. When laminate molding is prepared without applied pressure, the resin content in the laminate is increased, and tends to lack flexural rigidity. A method of continuous press molding to increase the base content of the laminate has therefore been desired.

In this connection, methods for continuously producing a laminated sheet and apparatus therefor which include a pressing step and achieve high productivity have been proposed in JP-A-56-144151 and JP-A-62-116116 (the term "JP-A" as used herein means an "unexamined published Japanese patent application") and in the proceedings of the 37th Annual Conference, Reinforced Plastics/Composites Institute, The Society of the Plastic Industry, Inc., Jan. 11 to 15, 1982. JP-A-62-116116 discloses an apparatus wherein resin-impregnated prepreg webs in roll form are continuously press-molded in a pressurizing chamber filled with a pressurizing medium while travelling on an endless belt. However, this method employs prepregs in roll form, and thus also results in the above-noted disadvantages.

On the other hand, it is conventional to continuously produce a laminated sheet by sufficiently impregnating a thermosetting resin solution into a fibrous base on continuous length such as kraft paper so as not to leave voids, layering a plurality of the impregnated bases, and heating the laminate with or without pressure to cure the resin solution. In these techniques, when the resin solution is cured without pressure, the resulting laminated sheet tends to have inadequate mechanical characteristics, such as impaired mechanical strength and rigidity, because a thermosetting resin layer is formed between the laminated bases and also because the base content of the laminated sheet is reduced.

In order to increase the base content and to reduce the resin content, a plurality of fibrous bases having been sufficiently impregnated with a resin composition so as to not leave voids may be layered and press-cured by the use of a double belt press, etc. However, a large proportion of the impregnating resin runs off from the base on pressing to readily contaminate the surrounding equipment. Additionally, it is very difficult, though economically important, to recover the large quantity of resin thus discharged.

## SUMMARY OF THE INVENTION

An object of the present invention is to eliminate the above-described disadvantages associated with the conventional production of laminated sheets and to provide method for continuously producing a laminated sheet having a high base content, comprising impregnating a thermosetting resin solution into a fibrous base of continuous length, layering a plurality of the resin-impregnated bases, and heat-pressing the laminate by means of a double belt press having endless belts, which results in substantially no run-off of the impregnating resin solution on pressing and leaves substantially no residual voids while providing a high base content.

The present invention is a method for continuously producing a laminated sheet comprising the steps of impregnating a fibrous base of continuous length with a thermosetting resin solution which neither essentially requires a drying step nor essentially produces reaction by-products such as gases or liquids during the curing reaction thereof and heat-pressing in which a plurality of the impregnated bases are layered and heat-pressed to cure the resin solution to provide an integral structure, Wherein said impregnating step is carried out by partially impregnating the base with the resin solution and said heat-pressing step is carried out in such a manner that the resin solution partially impregnating in the base penetrates throughout the base by using a double belt press composed of endless belts, said press applying a substantially even pressure over the entire pressurizing zone.

## BRIEF DESCRIPTION OF THE DRAWINGS

Figures 1 to 4 each illustrates an apparatus for continuously producing a laminated sheet according to the method of the present invention.

Figure 5 illustrates a step of partially impregnating a resin solution into a fibrous base employing the apparatus of Fig. 4.

Figure 6 is a diagram illustrating an apparatus for carrying our one embodiment of the method of the present invention.

Figure 7 is a diagram illustrating an apparatus for carrying our a second embodiment of the method of the present invention.

## DETAILED DESCRIPTION OF THE INVENTION

The fibrous bases of continuous length for use in the present invention include sheetings or webs made of glass fibers, e.g., glass fabric and glass mat; papers consisting mainly of cellulose fibers, e.g., kraft paper, aluminum hydroxide-blended paper, and linter paper; and inorganic fibers, e.g., asbestos fabric. In the case of using a paper base, paper consisting mainly of cellulose fiber, e.g., kraft paper, having an air-dried density (bulk specific gravity) of from 0.3 to 0.7 g/cc is preferred in view of impregnating properties and the quality of the resulting material.

It is preferable that the base be treated with methylolmelamine, methylolphenol, methylolguanamine, N-methylol compounds or the like treating agents, followed by drying prior to the impregnation with a thermosetting resin solution. Such treatment provides increased water resistance and reduced hygroscopicity to thereby improve electrical characteristics. The treatment is usually performed to a pick-up or absorption of from 5 to 35 parts by weight of the treating agent per 100 parts by weight of the base.

The thermosetting resin solution for use in impregnation in the method of the present invention is a resin solution which neither essentially requires a drying step nor essentially generates reaction by-products such as gases or liquids to an extent that whitening of the resin-impregnated bases takes place during curing. These characteristics are inherent in conventional unsaturated polyester resins (e.g., maleic acid anhydride/ethylene glycol/phthalic acid copolymer), allyl resins, epoxy acrylate resins (e.g., bisphenol A/acrylic acid copolymer) as well as side chain-double bond type resins hereinafter described. These resins have unsaturated groups and are characterized by crosslinking between the unsaturated groups or crosslinking derived from a vinyl monomer. Epoxy resins are also included in this category.

These thermosetting resins are liquids of low viscosity at the time of impregnation of the fibrous bases and, after curing tightly bond to the bases. In particular, the side chain-double bond type resins exhibit excellent impregnating properties when combined with a crosslinking vinyl monomer.

The side chain-double bond type resins noted above are polymers comprised of a main chain and side

chains, wherein the main chain is a stock polymer comprising a vinyl monomer unit having a functional group, to which a side chain having a carbon-carbon double bond capable of undergoing radical reaction is linked to the main chain via the functional group. The vinyl monomer units constituting the main chain must include vinyl monomer units having a functional group as essential units and, if desired, other vinyl monomer units having no functional group may also be present. The monomers from which the vinyl monomer units are derived are polymerized to form the main chain.

The vinyl monomers from which the above-stated essential units are derived include those having a carboxyl group as a functional group, e.g., acrylic acid, methacrylic acid, maleic anhydride, and maleic monoesters; those having a glycidyl group as a functional group, e.g., glycidyl methacrylate and glycidyl acrylate; and those having a hydroxyl group as a functional group, e.g., allyl alcohol, 2-hydroxyethyl methacrylate, 2-hydroxyethyl acrylate, 2-hydroxypropyl acrylate, and N-methylolacrylamide. Acrylic acid and methacrylic acid are particularly preferred.

The term "vinyl monomer unit having a functional group" from which the vinyl repeating unit is derived as used herein means a vinyl monomer unit having a functional group which is present as an active functional group in the formation of the main chain by polymerization to form a side chain linked to the main chain or which has been reacted with the side chain-forming monomers hereinafter described.

Specific examples of the vinyl monomers having no functional group include styrene, α-methylstyrene, chlorostyrene, vinyltoluene, vinyl chloride, vinylidene chloride, vinyl bromide, acrylonitrile, ethylene, propylene, butadiene, acrylic acid esters, methacrylic acid esters, vinyl acetate, vinyl propionate, maleic diesters, and ethylvinylbenzene.

The main chain comprised of these vinyl repeating units has a weight average molecular weight of from 5,000 to 400,000, preferably from 10,000 to 200,000. The weight average molecular weight of the main chain is appropriately selected from the above-recited range depending on the type of side chain employed. The molecular weight of the main chain influences the impregnation properties or physical properties as required for printed boards or electrical insulating laminates. If the molecular weight of the main chain is less than 5,000, the mechanical properties of the resulting laminate after curing are impaired. If the molecular weight of the main chain exceeds 400,000, the content of impregnation of the resin into the base is inferior. Further, the content of the functional group-containing repeating unit in the main chain relates to the density of the side chain, thus influencing the curing reactivity between side chains. A suitable proportion of the functional group-containing repeating unit should be selected accordingly. The side chain density of the main chain is preferably in the range of from 0.1 to 2 mols, more preferably from 0.4 to 1.5 mols, per 1000 g of the main chain.

The side chain of the above-described side chain-double bond type resin contains a 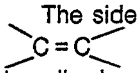 double bond at the terminal or middle thereof and constitutes a branching of the above-described main chain via the functional group. In this connection, any side chain capable of forming a crosslinked structure among other side chains on radical reaction with a crosslinking vinyl monomer can be used.

Typical examples of the side chain which may be present in the resin for use in the method of the present invention include those represented by formulae (I), (II), and (III):

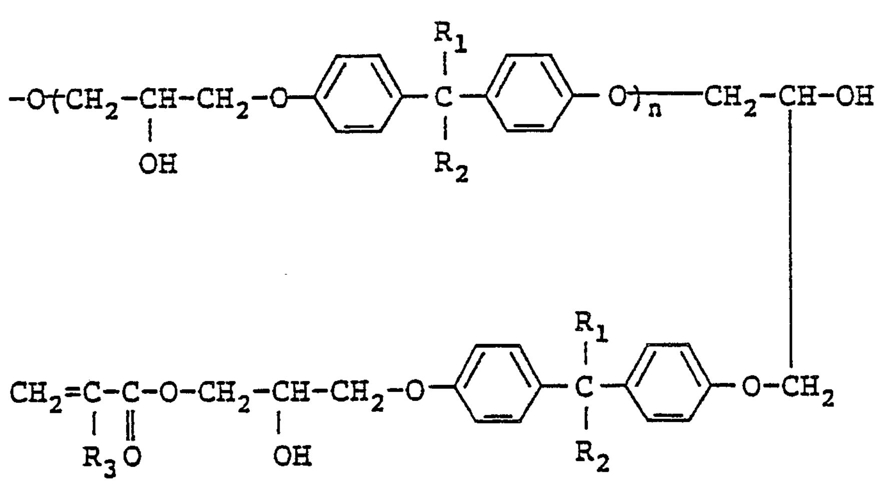

(I)

wherein $R_1$, $R_2$, and $R_3$ each represents a hydrogen atom or a methyl group; and n represents 0 or an integer of from 1 to 5;

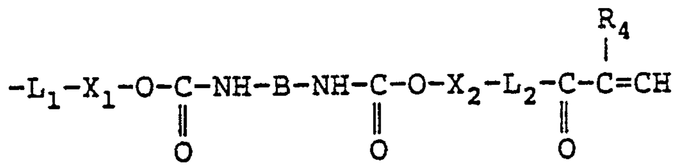

(II)

wherein $R_4$ represents a hydrogen atom or a methyl group; $L_1$ and $L_2$ each represents -O- or -NH-; $X_1$ and $X_2$ each represents a hydrocarbon group having from 2 to 16 carbon atoms or a hydrocarbon group having from 2 to 16 carbon atoms and containing an ether linkage; the carbon atom in $X_1$ and $X_2$ bonded to the oxygen atom adjacent to $X_1$ and $X_2$ is a primary or secondary carbon atom; and B represents an aliphatic, alicyclic or aromatic hydrocarbon group having up to 20 carbon atoms; and

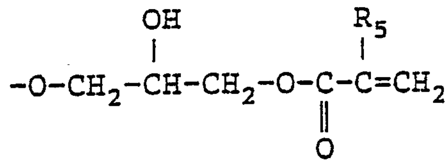

(III)

wherein $R_5$ represents hydrogen or a methyl group.

The side chain of the side chain-double bond type resins is not limited to the above-illustrated examples, and any side chain capable of forming a crosslinked structure among other side chains through radical reaction with a crosslinking vinyl monomer can be employed, e.g., a half ester of maleic acid group which is bonded to the main chain with the other carboxyl group in the form of an ester linkage.

In the syntheses of the side chain-double bond type resins, introduction of the side chain having a double bond at the terminal thereof into the stock polymer (main chain) can be achieved by various processes. Illustrative examples of the processes are described below.

(A) Reaction between a carboxyl group as a functional group of a main chain and one of epoxy groups of a compound having two epoxy groups, e.g., diglycidyl ether of bisphenol, and reaction between the remaining epoxy group of the compound and acrylic acid.or methacrylic acid.

(B) Esterification of a carboxyl group of a main chain with glycidyl acrylate or glycidyl methacrylate.

(C) Esterification of an epoxy group of a main chain with methacrylic acid or acrylic acid.

(D) Reaction between a diisocyanate compound and hydroxyethyl (meth)acrylate to obtain a reaction product consisting mainly of a monoisocyanate and containing substantially no diisocyanate compound, followed by reaction between the isocyanate in the reaction product and a hydroxyl group of the main chain.

While copolymerization for the main chain is first performed in the above-illustrated processes, it is possible, as a matter of course, that the reaction for side chain formation precedes polymerization of the vinyl monomers, which may comprise polymerization of the same monomers (homopolymerization) or differing monomers (copolymerization), to prepare a side chain-double bond type resin containing an acryloyl group or a methacryloyl group at the terminal of the side chain.

The crosslinking vinyl monomers include styrene, vinyltoluene, chlorosytrene, methyl acrylate, ethyl acrylate, butyl acrylate, 2-ethylhexyl acrylate, methyl methacrylate, ethyl methacrylate, butyl methacrylate, lauryl methacrylate, benzyl methacrylate, dibutyl maleate, dioctyl maleate, vinyl acetate, vinyl propionate, and divinylbenzene. These monomers may be used either individually or in combination thereof.

If desired, the thermosetting resin solution to be impregnated into a fibrous base may further contain a halogen-containing flame retarding agent or other compounds which participate in imparting flame retardancy, e.g., phosphoric acid esters, antimony trioxide, and aluminum hydroxide.

The viscosity of the thermosetting resin solution for use in the method of the present invention is selected depending on the end use of the laminated sheet, the pressure used in press molding, and the like and usually ranges from 0.05 to 500 poise at 25 °C. If the viscosity exceeds 500 poise, the impregnating properties of the resin are impaired, thereby leaving voids in the resulting laminated sheet. If the viscosity is less than 0.05 poise, the impregnating properties are satisfactory but the production of a substantially void-free laminated sheet is inevitably accompanied by run-off of a large amount of the resin solution.

The thermosetting resin solution is partially impregnated into a fibrous base of continuous length. In general, a thermosetting resin solution is impregnated into fibrous bases by a dipping method, a roll-coating method and the like, and hitherto it has been applied in a large amount excess to the total void volume of

the bases to ensure that the bases are well-impregnated with the resin solution. While fibrous bases generally possess voids in an amount (void content) of about 60 vol% based on the volume of the bases, the term "well-impregnated" implies the state wherein the resin solution is impregnated in an amount of more than 50 vol% based on the volume of the bases (but below the void content of the bases) though an optimum amount of the resin solution to be impregnated varies depending on the pressure applied for pressmolding of laminate of the impregnated bases. When the resin solution is applied in an amount less than the total void volume of the bases merely by the aforesaid methods, however, such well-impregnated bases are obtained only with difficulty. The partial impregnation of a thermosetting resin solution into fibrous bases according to the present invention means partially filling the voids of the bases with a thermosetting resin solution, and more specifically, it means that the resin solution is impregnated in an amount of not more than the total void volume of the bases under no applied pressure, i.e., the product of the volume of the bases under no applied pressure by their void content. When an applied amount of the resin solution is smaller than the total void volume of the bases under pressure, i.e., the product of the volume of the bases under pressure by the void content of the bases under pressure, whitening of the resulting laminate takes place due to lack of the impregnated resin solution. Thus, the total void volume of the bases under pressure is the lower limit of an impregnated amount of the resin solution in the partial impregnation.

The partial impregnation of the thermosetting resin solution can be carried out according to the following embodiments:

(a) A plurality of fibrous bases of continuous length are individually impregnated with a thermosetting resin solution to the same extent, but all voids of each base are not filled with the resin solution. A portion of the voids remain non-impregnated. In other words, the pickup or absorption of the thermosetting resin is uniform throughout the base in the machine direction or crosswise direction, but part of the voids is not impregnated with the resin. For example, in using kraft paper as a base whose void content is usually in the range of from 60 to 70 vol% (air-dried), the kraft paper is impregnated with a resin solution to the extent that the void content is reduced uniformly to about 30 to 40 vol% in any portion of the base.

(b) A plurality of fibrous bases of continuous length are individually impregnated with a thermosetting resin solution so as to have a higher pickup in the central portion thereof and less or no pickup in the side portions thereof. In other words, a distribution of resin concentration is provided along the widthwise direction of the base. For example, for a base being divided into three portions, the central portion thereof being impregnated at an impregnation rate of nearly 100%, with the side portions each being impregnated at an impregnation rate of 0 to about 30%; or, for a base being divided into five portions, the central portion thereof being impregnated at an impregnation rate of nearly 100%, with the portions outside the central portion each being impregnated at an impregnation rate of about 50%, and the outermost portions each being impregnated at an impregnation rate of 0 to about 30%. The term "impregnation rate" used herein means a percentage of the total volume of the voids filled with the resin solution in the base under no applied pressure based on the total void volume of the base under no applied pressure.

(c) A plurality of fibrous bases of continuous length are individually impregnated with a thermosetting resin solution so as to have a uniform impregnation rate over a central portion thereof without filling all the voids, with the side portions of from 1 to 5% from the both ends in the widthwise direction remaining non-impregnated. In using, for example, kraft paper, the resin solution is impregnated only into the central portion in the widthwise direction at an even void content of about 30 to 45 vol% therethrough. This embodiment is illustrated by reference to Figs. 4 and 5. A plurality of bases 1 are introduced into the apparatus, and a resin solution is applied only to the central portion of each of the bases by means of nozzle 16 providing for partial application. Impregnated base 19 comprised of resin-impregnated portion 17 (central portion) and resin-non-impregnated portions 18 (side portions) is thus prepared. The remaining referenced elements of Fig. 4 are as described for Fig. 1, which is described below. Fig. 5 is also further described below.

(d) A laminate composed of a plurality of resin-impregnated bases is prepared, wherein a distribution of resin concentration is provided in the layered, depth-wise direction thereof. For example, in a laminate composed of five bases, the impregnation rate of the central base is about 100%; from about 50 to 60% in each of the upper and lower bases on opposing sides and adjacent to the central base; and from 0 to about 20% in each of the outermost bases.

(e) A combination of embodiments (b) or (c) and (d). That is, a laminate composed of a plurality of resin-impregnated bases is prepared, wherein a distribution of resin concentration is provided both in the depthwise direction and in the widthwise direction, the pickup in the central portion, in both the depthwise and widthwise directions being higher than that in adjacent portions.

Even when the resin concentration is distributed in the widthwise direction of the base or in the depthwise direction of a laminate, if the resin pickup in the outside portion(s) is higher than that in the inside

portion, part of the resin solution tends to run off from the base on the subsequent heat-pressing step by means of a double belt press. Handling of the thus discharged resin solution is troublesome. Also, the resin does not spread and penetrate throughout the bases, thus failing to provide the requisite pickup.

Impregnation of the thermosetting resin solution into bases of continuous length can be performed by any known technique for coating, dipping, and the like appropriately selected depending on the selected embodiment for impregnation as above described.

The pickup of the thermosetting resin solution relates to the pressure applied in the subsequent pressing step by means of a double belt press. The pickup is controlled such that excessive flow of the resin solution to the outside of the base does not occur under applied pressure and such that the resulting laminated sheet contains substantially no voids therein. More specifically, it is desirable that amount of the resin solution discharged from the base laminate on pressing by means of a double belt press is controlled not to exceed 10%, preferably not to exceed 5%, and more preferably not to exceed 3%, of the total cured resin in the laminated sheet product.

A desired number of the thus prepared bases impregnated with the curing resin solution are then layered and heat-pressed by means of a double belt press which applies a substantially even pressure to the laminate over the entire pressurizing zone whereby the impregnating resin spreads to fill the voids of the laminate. The "even pressure" means the pressure which may vary by the difference within ±25%, preferably ±10%, of the average pressure over the entire pressurizing zone.

The term "partial impregnation of a thermosetting resin" pertains to the state of a fibrous base prior to heat-pressing. Therefore, the state of partial impregnation includes not only the above-mentioned state as a result of partial application of the resin solution onto a base but also a state obtained by applying a resin solution to fill substantially all the voids of each base and then removing the excess resin solution from the impregnated base or a laminate of the impregnated bases to an extent that each of the bases covered with the resin solution contains voids under no applied pressure. In the latter case, when the excess resin solution to be discharged upon heat-pressing is removed by application of pressure to the base, the base takes up air to form voids when released from the pressure, to thereby create a state of partial impregnation. Removal of the excess resin solution can be carried out by various methods such as blasting air, as well as squeezing through a pair of rollers. Squeezing is preferred because the resin can be continuously removed while also controlling the degree of removal.

Excess resin solution may be removed from each of the resin-impregnated bases prior to laminating or from a laminate comprised of a plurality of the resin-impregnated bases.

The amount of the resin solution to be removed relates to the pressure applied in the subsequent heat-pressing step for resin curing. Namely, the extent of resin removal is adjusted to be about the same as or slightly less than the amount of the resin solution that would run off if the impregnated base (or a laminate thereof) from which the excess resin solution has not been removed were to be pressed by a double belt press in the subsequent heat-pressing step. If too much of the excess resin is removed, voids would be present in the laminated sheet obtained after heat-pressing, thus reducing the moisture resistance of the laminated sheet. If an insufficient amount of the excess is removed, pressing by means of a double belt press results in the run-off of a large quantity of the resin solution, thereby causing handling problems. More specifically, it is economically desirable to remove the excess resin solution to the point at which the resin remaining in the base is reduced to 110% or less based on the cured resin in the resulting laminated sheet product, and particularly 101% or less in cases wherein the discharged resin is not recovered.

Thereafter, the laminated resin-impregnated bases are heat-pressed by means of a double belt press to cure the resin.

The double belt press applies a substantially even pressure over the entire pressurizing zone and comprises, for example, a pair of upper and lower endless belts made of stainless steel having a thickness of about 1 mm such that a laminate of the resin-impregnated bases sandwitched therebetween may be uniformly pressed over the entire pressurizing zone.

Specific examples of the double belt press for use in the method of the present invention are illustrated below by reference to the accompanying drawings.

(1) A structure containing a plurality of pairs of rolls for applying a pressure on the upper and lower belts sandwitched therebetween, each roll having a diameter of not more than 50 mm, the ratio of the roller pitch to the roll diameter being adjusted to 1.2 or less so as to minimize pressure reduction between adjacent rolls, as disclosed in JP-A-56-144151. The rolls may be fixed, or may revolve around each of pressing plates provided above and below the upper and lower endless belts, respectively. If the roll diameter is too large, the spacing between rolls becomes too great, thus causing variation in the pressure exerted on the base.

Fig. 3 illustrates an apparatus for the continuous production of a laminated sheet according to the

method of the present invention, wherein the above-described double belt press is employed. In the Fig. 3, each of the continuous base lengths 1 held by feed rolls 2 are continuously fed to impregnating apparatus 3 comprising an impregnating bath filled with an impregnating resin solution to provide resin-impregnated bases 1′. The resin-impregnated bases 1′ are continuously forwarded into double belt press 4 where the bases are united into a single body under pressure and heat and where the resin solution is cured to obtain laminated sheet 10, which is then cut to the desired size with a cutter, etc. (not shown).

The double belt press 4 used in this embodiment essentially comprises pairs of drums 5, 5a, endless belts 6, multiple pairs of press rolls 7 and curing apparatus 8. The drums pairs 5 and 5a each form a complementary pair, each drum thereof rotating in opposite direction to the complementary drum, with the bases 1 being sandwitched therebetween. An endless belt 6 made of a metal, e.g., stainless steel is provided under tension around the drums 5 and 5a which are positioned forward and backward in the running direction on one side of the bases 1 and which rotate in the same direction. On the endless belt 6 on the straight line connecting the drums 5 and 5a, a plurality of pairs of upper and lower press rolls 7 are provided in addition to curing machine 8 comprising a heater, etc. for curing the resin solution in the bases 1. According to this embodiment, base 1 fed from feeder 2 is impregnated with a resin solution in impregnating machine 3 and then forwarded to double belt press 4 while remaining uncured. The impregnated base 1 is sandwitched between endless belts 6, pressed by the pairs of press rolls 7 and heated by means of curing machine 8 while travelling as the endless belts rotate. Thus, the resin solution is cured to provide a laminated sheet 10 composed of a plurality of bases 1.

(2) A structure containing a pair of press plates for applying pressure on a pair of upper and lower endless belts sandwitched therebetween which may further contain a pressurizing medium circulating between the press plate and the endless belt for the purpose of lubrication, as disclosed in JP-A-62-116116.

(3) A structure having revolving small diameter rolls wherein a chain having a plurality of small diameter rolls is provided between the above-described press plate and endless belt 6, as disclosed in the proceedings of the 37th Annual Conference, Reinforced Plastics/Composites Institute, The Society of the Plastics Industry, Inc., Jan. 11 to 15, 1982, Session 10-D, pages 1 to 5. The chain is revolved around the press plate with the revolution of the endless belt 6 whereby base 1 is pressed by the press plate via the small diameter rolls.

(4) A structure comprising a pair of containers containing a pressurizing medium with a pair of upper and lower endless belts being sandwitched therebetween, the opening of the container contacting with the endless belt such that the pressurizing medium directly exerts pressure on the endless belt. This type of double belt press is particularly advantageous since the variation of applied pressure throughout the pressurizing zone is small.

Fig. 1 illustrates an apparatus for the continuous production of a laminated sheet according to the method of the present invention, in which the above-mentioned type (4) of double belt press is employed. In Figure 1, each of the continuous base lengths 1, held by feed rolls 2, are continuously fed to impregnating apparatus 3, to provide resin-impregnated buses 1′. In the Figure 1, double belt press 4 is composed of pairs of drums 5, 5a, a pair of endless belts 6, pressurizing chamber 9, and pressurizing medium 11 comprising a high temperature fluid. Pressurizing medium feeder 15 comprises pump 12 and heater 13 connected to pressurizing chamber 9 via pipe 14. The drum pairs 5 and 5a each form complementary pairs, each drum thereof rotating in opposite direction to the complementary drum, with resin-impregnated bases 1′ being sandwitched therebetween. Endless belts 6 under tension are provided around the drums 5, 5a which are positioned forward and backward in the running direction on each side of the bases 1′ and which rotate in the same direction. Pressurizing chamber 9 is provided on the back of each of the endless belts 6, the pressurizing chamber 9 containing pressurizing medium 11 thus providing the heat and pressure required for the curing of the impregnating resin and integral molding of the bases 1′. The shape of the pressurizing chamber 9 may be varied as long as the endless belts 6 each constitute one side of the chamber. The pressurizing chamber 9 contains the pressurizing medium 11 for applying heat and pressure to the impregnated bases 1′ via the endless belt 6. To the pressurizing chamber 9 is connected pressurizing medium feeder 15 comprising pump 12 for feeding the pressurizing medium 11 and heater 13, e.g., an electrical heater, for heating the pressurizing medium 11 connected via pipe 14. The heater 13 may be incorporated into the pressurizing chamber 9. The pressurizing medium 11 is circulating through the feeder 15 and the chamber 9 by means of the pump 12 so that replenishment of the medium and application of pressure and heat to the medium may be conducted outside the chamber 9. Heating of the chamber 9 can be effected indirectly by heating the medium 11 by means of the heater 13. Pressurizing medium 11 can be successively supplied by means of the pump 12 to the chamber 9 in an amount equal to the amount of the medium which runs off from the chamber 9 with the running of the endless belts 6 so as to maintain the inner pressure of the chamber 9 constant. The impregnated bases 1′ sandwitched

between the pair of endless belts 6 are heat-pressed with the pressurizing medium 11 in the chamber 9 whereby the resin solution spreads uniformly throughout the fibrous bases to fill the voids and is cured to unite the bases into a single body. The endless belt 6 to be used in this double belt press 4 is preferably a sheet of a metal, e.g., stainless steel, of about 0.5 to 3 mm in thickness. Any kind of fluid can be used as the pressurizing medium 11 as long as it is fluid under the operating conditions of the double belt press 4. Examples of such a medium include gases, e.g., air and nitrogen; liquids, e.g., lubricating oils, heat transfer oils and cylinder oils; waxes or low-boiling polymers, e.g., polyethylene wax and paraffin; and low-boiling metals, e.g., solders and Wood's metal.

According to the above-described heat-pressing system in which a plurality of impregnated bases are heated and pressed by means of a pressurizing medium, the pressure is uniformly exerted on the entire surface of the endless belts, thus providing sufficient pressing and heating. As a result, incorporation of air between bases or interlaminar separations is avoided. Further, since variation of the pressure due to varied thicknesses of the endless belt is absorbed by fluidity of the pressurizing medium, a laminated sheet having a uniform thickness with high dimensional precision is obtained.

In the apparatus of Fig. 1, three resin-impregnated bases are forwarded to the double belt press where they are layered and heat-pressed. However, any desired number of impregnated bases of from 2 to about 20 may be layered immediately after impregnation by the use of a pair of rolls for each base, or using like means, and then forwarded to the double belt press.

In the heat-pressing step using any of the above-described double belt presses, the variation in applied pressure, particularly in the form of a pulsating pressure in the direction of machine flow, should be minimized. Not only does a variation in applied pressure make it difficult to remove voids in the bases but tends to re-entrap air in the bases while in the pressurizing zone. Therefore, the variation in pressure is preferably controlled to below ±25% and below ±5 kg/$cm^2$.

The pressure to be applied is selected to obtain the desired base content in the resulting laminated sheet, and varies depending on the kind of impregnating resin solution or the kind of the base used. The applied pressure typically ranges from 1 to 100 kg/$cm^2$G, and preferably from 10 to 50 kg/$cm^2$G. If it is lower than 1 kg/$cm^2$G, the base content hardly increases in the pressing step, the ability to discharge air is reduced and tends to produce a laminated sheet containing air bubble voids. On the other hand, if the applied pressure exceeds 100 kg/$cm^2$G, the resulting base content of the laminated sheet becomes too high, thus causing interlaminar separation and a reduction in mechanical strength. In addition, a pressure exceeding 100 kg/$cm^2$G is unnecessary for the removal of air bubbles.

The heating temperature for press molding is usually selected in the range of from 50° to 200° C, and varies depending on the kind of the thermosetting resin solution and curing catalyst for radical reaction (e.g., peroxides) employed. At temperatures below 50° C, the required curing time would be uneconomically long. At temperatures exceeding 200° C, the curing reaction proceeds abruptly causing internal strain or bubbling.

In the heat-pressing step using the double belt press, the resin solution which has been partially impregnated into each fibrous base or a laminate of fibrous bases penetrates into the non-impregnated portion of the base or laminate to thereby provide a uniformly impregnated base or laminate. A steep pressure gradient is provided in the laminate in the direction opposite to the running direction when the laminate enters into the double belt press. This pressure gradient promotes penetration and impregnation of the resin solution into the non-impregnated portion of the bases or laminates thereof and, at the same time, accelerates the displacement of remaining air in the voids of the bases with the resin solution. A part of air thus displaced is continuously driven within the laminate to the direction opposite to the running direction and out of the laminate under the applied pressure of the double belt press. Some of the displaced air is also driven toward both edges of the laminate by the pressure gradient provided in the widthwise direction and out of the laminate together with a small amount of the resin solution. A substantially void-free laminated sheet is thus obtained. Because the bases are only partially impregnated with the thermo-setting resin solution, pressing by the double belt press is attended with no substantial run-off of the resin solution. That is, the resin solution that is partially impregnated into the bases nearly corresponds to the amount of the resin in the resulting laminated sheet such that excess resin solution is not present in the laminate before pressing. By avoiding run-off of the resin solution, the need to recover the discharged resin solution is eliminated and contamination of the double belt press by resin run-off is also prevented, thereby simplifying the structure of the double belt press. For instance, where partial impregnation of the resin solution is carried our according to the above-described embodiment (c) as shown in Fig. 5, in the laminated sheet having passed through pressurizing chamber 9, a resin-cured portion 20 is formed, the width of said portion 20 being extended toward both edges over the width of resin-impregnated portion 17 and resin-non-impregnated and unhardened portions 21, the width of said portions 21 being smaller than

that of corresponding resin-non-impregnated portions 18 at both ends of the resin-cured portion 20.

The base content in the thus obtained laminated sheet usually ranges from 30 to 80% by weight, but varies depending on the kind of base or thermosetting resin solution employed. For example, with kraft paper as the base and the above-described side chain-double bond type resin being used as a resin solution, the base content preferably ranges from 35 to 65% by weight. If the base content is less than 35% by weight, the resulting laminated sheet tends to have insufficient mechanical strength or flexural rigidity. If the base content exceeds 65% by weight, the laminated sheet tends to delaminate, and the moisture resistance and ability to punch the laminate deteriorates.

In a preferred embodiment of the method of the present invention, the uncured laminate is heat-pressed, allowing the partially impregnated resin solution to penetrate throughout the entire laminate. The resin solution is thereby continuously semi-cured to the extent that the base no longer undergoes elastic recovery, and the resin is then continuously postcured by heating without the application of external pressure, i.e., zero gauge pressure. According to this embodiment, a laminated sheet free from warpage or waviness and having good dimensional accuracy is obtained. In this embodiment, the resin solution is semi-cured to the extent that the laminate does not expand in the layered direction due to the elastic restoring force of the compressed bases upon pressure release and also to the extent that the laminate may withstand the subsequent heating step wherein externally applied pressure is absent. If the extent of semi-curing is insufficient, the bonding strength of the semi-cured resin to the base is so weak that the bases expand and restore in form to allow air outside the laminate to re-enter into the laminate thus producing air bubbles and voids in the laminated sheet. On the other hand, if the degree of semi-curing is too great, the resulting laminated sheet becomes warped or incurs surface waviness. The temperature for the semi-curing varies depending on the kind of the thermosetting resin solution or a curing catalyst used, and usually ranges from 50 to 200°C, and preferably from 100 to 200°C. At temperatures lower than 50°C, the time required for the desired degree of curing becomes uneconomically long. At temperatures exceeding 200°C, internal strain tends to be generated due to the extreme rate of curing, or if using a crosslinking vinyl monomer, interlaminar separation is liable to occur due to evaporation of the monomer.

The thus semi-cured laminate is then continuously heated without the application of external pressure by means of a heating furnace, etc. to substantially complete curing of the thermosetting resin. The continuous curing without the application of external pressure produces a laminated sheet free from warpage or surface waviness. When the laminate is heat-pressed by means of the double belt press, the resin solution is forced to penetrate or impregnate throughout the base, thereby producing stress in the laminate. If the curing of the resin under pressure proceeds excessively, this stress would remain as a residual stress. It is believed, therefore, that such stress is relieved by releasing the pressure while the resin is in a semi-cured state and then effecting postcuring in the absence of applied pressure. If the laminate is cut immediately after semi-curing, followed by substantial completion of the curing reaction, the stress remains in the vicinity of the cut surfaces thus causing warpage therearound. Hence, in order to obtain a laminated sheet of high dimensional precision, the curing must be completed while the laminate is continuously travelling.

The temperature of heating during the continuous travelling in the absence of applied pressure is usually in the range of from the temperature in the preceding semi-curing heat pressing step up to 200°C. At temperatures lower than the heat pressing temperature, completion of curing would uneconomicaly require too much time, or, curing may also not proceed. At temperatures higher than 200°C, the laminated sheet or a metal foil laminated thereon may become discolored or warpage may result.

After substantial completion of the curing by heating in the absence of applied pressure, the laminated sheet is then cut to a prescribed size with a cutter, e.g., a guillotine cutter, and, if desired, further subjected to correction of warpage or edgewise treatment to obtain the end product. The warpage correction or lenghthwise edgewise treatment may be performed continuously after the heating treatment and before the cutting. In particular, a metal foil-clad (single side) laminated sheet frequently requires warpage correction since it tends to warp at room temperature due to shrinkage on curing or due to a difference in the coefficient of linear expansion between the metal foil and the base containing the cured resin. The single metal foil-clad laminated sheet is desirably cooled after completion of curing to a prescribed temperature, followed by continuous correction of the warpage using a warpage correcting machine, such as rolls, and then cut to size. During the warpage correction, the laminated sheet is preferably maintained at near room temperature, usually about 50°C or lower, depending on the kind of the base or thermosetting resin solution employed.

Fig. 6 illustrates an apparatus which is suitable for carrying out the above-described preferred embodiment. The apparatus comprises feed rolls 2 for feeding bases 1, impregnating baths 3 containing an impregnating thermosetting resin solution, double belt press 4 for heat pressing, heating furnace 22 for heat

treatment under contact pressure, feed roll 23 for feeding a metal foil, applicator 24 for coating an adhesive to the metal foil, and heating furnace 25 for preheating the adhesive. The double belt press 4 used herein is the above-described type (4) using a pressurizing medium, comprising drum pairs 5 and 5a, endless belts 6, which are provided around the drums 5 and 5a on opposing sides of the layered bases 1, pressurizing chamber 9, and pressurizing medium 11 comprising a high temperature fluid which is contained in the pressurizing chamber 9.

In carrying out the method of the present invention using the apparatus of Fig. 6 a plurality of bases 1 comprising, for example, paper are synchronously fed from feed rolls 2 and impregnated with a thermosetting resin solution in the respective impregnating baths 3. The resin-impregnated bases are forwarded between endless belts 6 in layered form. Concurrently, a metal foil, e.g., a copper foil, is fed from roll 23. After application of an adhesive by means of applicator 24, the metal foil is preheated in heating furnace 25, laminated on the base 1 as an outermost layer, and introduced between endless belts 6 where a laminate of resin-impregnated bases and the metal foil are heat-pressed to semi-cure the resin solution. Then, the laminate is heated in the absence of applied pressure in heating furnace 22 to thereby substantially complete curing of the resin. The laminate is then cooled in cooling chamber 26 to obtain a laminated sheet. Thereafter, the laminated sheet is continuously passed between rolls 27 to correct deformation in the longitudinal direction and then between rolls 28 to correct deformation in the crosswise direction to thereby correct warpage in both the longitudinal and crosswise directions. The laminated sheet is cut to a prescribed size with guillotine cutter 29 in a continuous manner to obtain a single metal foil-clad laminated sheet 30.

While the foregoing description has been directed to the production of single metal foil-clad laminated sheets, the above-described apparatus can also be applied to the production of laminated sheets having no metal foil. In such cases, only the resin-impregnated bases 1 are forwarded to the double belt press in a layered form.

In the production of a metal foil-clad laminated sheet, a metal foil is provided on one or both sides of a laminate of resin-impregnated bases either simultaneously with or shortly after the layering of the impregnated bases and the metal foil-clad material is then transferred to the double belt press. The metal foil for use in the laminated sheet includes electro lytic copper foil for printed circuit boards, which is preferable from the viewpoint of corrosion resistance, the etching properties thereof, and adhesion. In addition, an electrolytic iron foil and an aluminum foil may also be used. The metal foil usually has a thickness of from 10 to 100 µm.

The surface of the metal foil to be adhered to the laminate is preferably first subjected to a surface roughening treatment to improve adhesion. Adhesion of the metal foil to the resin-impregnated base is effectively achieved by the use of an adhesive. Useful adhesives preferably include those which do not produce undesired reaction by-products during curing and are liquids or semi-fluids, that is, preferably having a viscosity of 5,000 poise or less. Examples of preferred adhesives include epoxy-acrylate adhesives, epoxy resin adhesives, polyisocyanate adhesives, and various modified adhesives thereof. The epoxy adhesives preferably include a mixed system composed of a bisphenol A type epoxy resin and a curing agent, such as a polyamide resin and an amine. Application of such an adhesive makes it possible to produce a metal foil-clad laminated sheet having excellent adhesion of the metal foil, resistance to soldering temperature, and electrical insulating properties.

When the adhesive is applied onto a metal foil, it may be precured or semi-cured by heat treating at a temperature of from 60 to 150°C for 2 to 7 minutes. The adhesive may be applied simultaneously with layering of the impregnated base. The adhesive is usually applied in a thickness of from about 10 to 100 µm, preferably from 20 to 50 µm.

The thickness of the laminated sheet fabricated according to the method of the present invention varies depending on the type of the base, the composition of the thermosetting resin solution, the intended end use of the laminated sheet, and the like, and usually ranges from 0.5 to 30.0 mm.

In another embodiment according to the method of the present invention, the impregnation step is carried out such that each base is impregnated with the resin solution in a substantially uniform manner in the widthwise direction. The heat-pressing step is carried out such that the resin-impregnated base is heat pressed by means of a double belt press comprising endless belts which is positioned vertically above the impregnation line and which exerts a substantially even pressure over the entire pressurizing zone while allowing the resin solution to penetrate throughout the base. According to this embodiment, the resin solution which runs off from the base on pressing can be rapidly removed from the equipment surfaces, and a substantially void-free laminated sheet having a high base content is thus provided.

In this embodiment, the impregnation of the thermosetting resin solution into a base of continuous length is preferably effected in a partial manner as stated above. That is, the resin solution is partially

impregnated in a substantially uniform manner in the widthwise direction, without filling all of the voids in the base. For example, in using kraft paper as a base, the impregnation is performed to the extent that the void content is reduced to about 30 to 45% by volume at any portion of the base. The amount of the resin required for filling all of the voids in the base depends on the pressure applied in press molding. However, with only an overall application of a 1% excess of the resin, the resin solution is present in an amount less than that required to fill all of the voids in the base, whereby the resulting base appears to be white due to voids left in the base, so-called "whitening". An excess amount of 50% or more of the resin is not only unnecessary for impregnation, but the excess resin only slightly flows downward by gravity, thereby increasing the proportion of the resin which flows to the side of the machine to cause contamination.

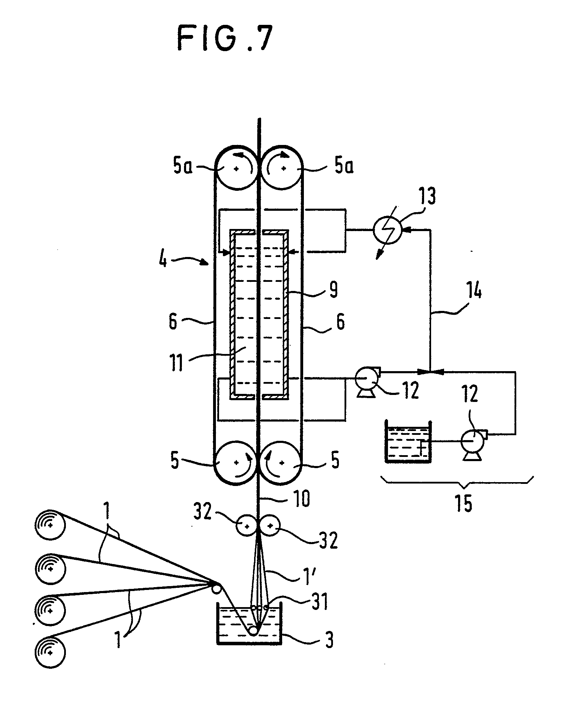

The impregnation of the thermosetting resin solution into bases of continuous length can be carried out by a method appropriately selected from known techniques, including a combination of dipping and squeezing, coating, and the like. For example, as shown in Fig. 7, a plurality of bases 1 are fed to impregnating bath 3, where they are impregnated with a resin solution. Spacers 31 are provided in the impregnation bath so that the bases are separated apart from each other to allow the resin solution to be present between the bases. The resin-impregnated bases 1′ are then passed through squeeze rolls 32, where excess resin solution is removed to thereby provide for partial impregnation and, at the same time, a plurality of resin-impregnated bases 1′ are laminated. The remaining referenced elements of Fig. 7 are as described for Fig. 1.

The pickup of the thermosetting resin solution by the bases is related to the amount of pressure applied to the impregnated base laminate in the subsequent heat-pressing step. The pressure to be applied is adjusted to provide a laminated sheet of a prescribed thickness having substantially no air bubbles. It is desirable to adjust the pickup of the resin solution such that the amount of the resin solution discharged downward on pressing under the above applied adjusted pressure is not more than 50%, particularly not more than 10%, of the cured resin in the final laminated sheet product. If the pickup is less than the proper amount in relation to the pressure applied in the pressing step, air bubbles tend to be present in the resulting laminated sheet, resulting in overall whitening of the laminated sheet.

The resin-impregnated bases of continuous length are layered in a laminate form and simultaneously or subsequently heat-pressed in the upright double belt press which exerts a substantially even pressure over the entire pressurizing zone and which is positioned substantially vertically (generally 60 to 90° and preferably 75 to 90°) and directly above the impregnation bath, whereby the impregnating resin spreads to fill the voids of the base.

In this embodiment, since the double belt press is upright, the excess resin solution thus discharged flows downward, and the spread of the resin solution in the widthwise direction is extremely limited. Accordingly, while the portion of the base which becomes impregnated with the resin solution increases in width toward both edges on pressing, the proportion of the increase is as little as about 1% based on the width of the laminate.

Additional embodiments of the method according to the present invention are described below.

(i) An embodiment in which the heat pressing step is carried out using a double belt press comprising two endless belts and a pair of pressurizing chambers containing a pressurizing medium comprising a fluid, wherein each of said endless belts constitutes one of the sides of each of said pressurizing chambers.

(ii) The embodiment of (i) above, which further includes laminating at least one metal foil on the plurality of resin-impregnated bases simultaneously or successively, either in the double belt press or in a preceding step, wherein said metal foil can be the outermost layer of the laminate.

(iii) An apparatus for continuously producing a laminated sheet comprising a letoff gear for feeding a plurality of bases of continuous length, an impregnation machine for impregnating a resin solution into each of the bases, and a double belt press composed of two endless belts, said letoff gear, impregnation machine and double belt press being connected in series with respect to product flow, said double belt press having a pair of pressurizing chambers containing a pressurizing medium comprising a fluid in the area where each of the endless belts and the resin-impregnated base laminate are in contact, and wherein each of said endless belt constitutes one of the sides of each of said pressurizing chambers.

In the embodiments (i) and (ii), a plurality of resin-impregnated bases are layered in the double belt press or in a preceding step and then heat-pressed in the double belt press. The resin solution is cured by the heat of the pressurizing medium (fluid) and the bases are united into an integral body by the pressure of the pressurizing medium. Thus, the entire surface of the base laminate is pressed uniformly to continuously provide a laminated sheet. The resulting laminated sheet contains no air bubble voids between the bases or inside the bases, is not prone to interlaminar separation, and thereby exhibits high mechanical strength. In addition, since any thickness variation of the endless belt is absorbed by fluidity of the

pressurizing medium, the laminated sheet has a high dimensional precision with a small variation in thickness.

In the embodiment (ii), since the pressing is performed uniformly, thereby greatly reducing the localized flow of the resin solution within the base, a laminated sheet is continuously obtained having a wrinkel-free metal foil on one or both sides thereof.

One example of the apparatus described in (iii) above is shown in Fig. 1. According to the Fig. 1, from 2 to 20 resin-impregnated bases 1′ are layered in double belt press 4 or in the preceding step and then heat pressed into an integral body in the double belt press.

The resin-impregnated bases 1′ are sandwitched between endless belts 6, and forwarded into double belt press 4, where the bases are pressed while curing the resin solution to unite the bases into a single body so as not to separate. Pressurizing chamber 9, provided in the double belt press 4, is charged with pressurizing medium 11 of a prescribed temperature and under a prescribed pressure, said temperature being appropriately selected depending on the type of the resin solution and curing catalyst employed, and the pressing conditions, such that the base laminate is integrally-molded under the proper conditions. The temperature of the pressurizing medium 11 contained in the pressurizing chamber 9 usually ranges from 50 to 200° C, but varies depending on the factors as stated above. If the temperature is less than 50° C, curing of the resin solution is too slow to be economically useful. At temperatures higher than 200° C, curing of the resin solution proceeds too rapidly, causing internal stress or air bubbles in laminated sheet 10.

The inner pressure of the pressurizing chamber 9 is appropriately selected depending on the type and physical properties (particularly viscosity) of the resin solution used, the heating conditions, and the desired resin content of a laminated sheet. The inner pressure is usually selected from a range of about 1 $kg/cm^2G$ to 10 $kg/cm^2G$ or even higher. While being sandwitched between the endless belts 6, and heated and pressed by the pressurizing medium 11 under the above-recited conditions, the resin solution is thereby cured. At the same time, the plurality of bases are pressed and bonded into a single body to thereby provide laminated sheet 10. During the heat pressing, the thickness variation of the endless belts 6 is absorbed by the fluidity of the pressurizing medium 11 so that such an undesired destorting force does not act on the laminated sheet 10. As a result, the resulting laminated sheet 10 has a good thickness precision. This factor distinguishes the above-described embodiment from a conven tional pressing system, i.e., a system using a pair of flat press plates developed for uniform pressing over the entire surface of a base laminate or a system using a number of revolving small diameter rolls developed for substantially uniform pressing. In these conventional systems, since the press plate is rigid, it does not absorb variation of the pressure due to varied thicknesses of the press plate, thus resulting in poor dimensional precision in the thickness direction.

Further, in this embodiment, since the base laminate is unformly pressed by the pressurizing medium 11 indirectly via the endless belts 6, incorporation of air in between the bases is prevented so as to provide a high bonding strength between the bases. Therefore, the resulting laminate 10 is not prone to delamination.

Furthermore, since the base laminate is uniformly pressed via the endless belts 6 and in the absence of localized pressing, the resin solution in the impregnated base is prevented from flowing locally, such that the resulting laminated sheet 10 is free from wavy surface unevenness.

The embodiment (ii) stated above can be carried out by using, for example, the apparatus shown in Fig. 2. The apparatus of Fig. 2 is different from that of Fig. 1 in that the former further includes additional feed mechanism 2a from which metal foils 1a, 1a are provided and layered on the plurality of resin-impregnated bases as an outermost layer. The apparatus is operated otherwise similarly to the apparatus of Fig. 1 to produce metal-clad laminated sheet 10a. Each of the referenced elements of Figure 2 are similarly described by the corresponding referenced elements of Figure 1. The metal foil to be adhered on the surface of the laminated sheet includes a copper foil, an iron foil, an aluminum foil, and a stainless steel foil. In using the resulting metal-clad laminated sheet 10a in electrical circuits, an electrolytic copper foil or a rolled copper foil is preferred. For the purpose of improving adhesion of the metal foil to bases 1, it is preferable to subject the surface of the metal foil 1a to surface roughening. In order to further enhance the adhesion, an epoxy resin adhesive may also be applied. Specific examples of useful adhesives have been described above.

Adhesion between the base and the metal foil, particularly a copper foil, can be further improved by incorporating (meth)acrylic acid into the impregnating resin solution. In this manner, a copper-clad laminated sheet suitable for use as a printed circuit board can be obtained, which is free from a so-called land lifting phenomenon, i.e., lifting of a metal land around throughholes formed in a copper-clad laminate. (Meth)acrylic acid is usually added for this purpose in an amount of from 0.5 to 20 parts, preferably from 3 to 15 parts, by weight per 100 parts by weight of the thermosetting resin solution.

A resin solution containing (meth)acrylic acid may be selectively used in the area of the base which is to come into contact with a metal foil, while the remaining area of the base may be impregnated with a resin composition comprising a curable prepolymer and a crosslinking vinyl monomer wherein the (meth)-acrylic acid is absent.

Hence, according to the embodiment (ii) using the above-described apparatus, a laminate composed of a plurality of bases and a metal foil on one or both sides thereof can be uniformly pressed by means of pressurizing medium 11 via endless velts 6 without resulting in the localized flow of a large proportion of the impregnating resin in the impregnated base. Therefore, the resulting laminated sheet 10a is free of wrinkles in the metal foil, exhibits good bonding between the base and the metal foil, and has a smooth and defect-free appearance.

In this embodiment, replacement of metal foil 1a with release film made of high polymers, etc. results in the production of laminated sheet with release film on one or both sides thereof. The release film which can be used includes a polyester film, a cellophane film, release paper, a polypropylene film, an aluminum foil, and a stainless steel foil. The release film can be released from the laminated sheet to obtain an ordinary laminated sheet 10. By using the release film, the endless belts 6 do not directly contact with the outer surface of the laminated sheet during pressing in the double belt press 4. This is advantageous in that the surface of the endless belts are prevented from being contaminated with the uncured resin, while the surface of the laminated sheet 10 is kept clean until use.

The release film may also be removed from the laminated sheet after completion of the press molding and rolled up for further use.

The present invention is now illustrated in greater detail with reference to the following Examples, but it should be understood that the present invention is not deemed to be limited thereto. In these examples, all the percents and parts are given by weight unless otherwise indicated.

Preparation of Side Chain-Double Bond Type Resin:

In a 3000 ml-volume separable flask equipped with a stirrer, a thermometer, an inlet for gas introduction, a reflux condenser, and a dropping funnel were charged 35 g (0.41 mol) of methacrylic acid, 400 g of methyl ethyl ketone, 800 g (7.7 mol) of a styrene monomer, 5.0 g of azobisisobutyronitrile, and 12 g of dodecylmercaptan, and polymerization reaction was effected at 75 to 80 °C for 10 hours in a nitrogen atmosphere. The polymerization reaction was ceased by the addition of 0.5 g of hydroquinone. The resulting polymer solution comprised a styrene-methacrylic acid copolymer having a weight average molecular weight of about 50,000; ratio of polymerization of styrene monomer = 76%; ratio of polymerization of methacrylic acid = 93%.

Separately, 360 g (1 mol) of "Epikote 827" (a trade name of an epoxy resin produced by Yuka Shell Epoxy Co.), 138 g (1.6 mol) of methacrylic acid, 1.2 g of benzyldimethylamine, and 0.12 g of parabenzoquinone were charged in the same type of a reaction vessel as described above, and the mixture was allowed to react at 120 °C for 3 hours in a nitrogen atmosphere. The acid value of the mixture became virtually zero after completion of the reaction, and a vinylating reagent was obtained containing an unsaturated group-containing epoxy resin. The entire quantity of the above prepared polymer solution was added to the vinylating reagent, and 5 g of triphenylphosphine and 0.10 g of parabenzoquinone were added thereto, followed by heating. The methyl ethyl ketone solvent was distilled off at a boiling point of 110 °C, and the reaction was continued for 5 hours at that temperature. After completion of the reaction, the content of the unsaturated group-containing epoxy resin reduced to about 15% based on the initial content. Evaporation by heating under a pressure of 30 to 50 mmHg was continued while adding 1000 g of a styrene monomer in divided portions. The operation was stopped at the point when the methyl ethyl ketone content in the distillate reached 0.1% or less. A yellowish brown resin solution was thus obtained containing a curable prepolymer having a nonvolatile content of 52% and a viscosity of 6.12 poise (at 25 °C).

## EXAMPLE 1

SAMPLES 1 TO 8 AND COMPARATIVE SAMPLES 1 TO 4

Each of 8 sheets of commercially available kraft paper of continuous length (base weight: 135 g/m$^2$;

density: 0.49 g/$cm^3$) were impregnated with N-methylolmelamine ("Nicaresin S-305", a trade name of Nippon Carbide Inds. Co., Ltd.) so as to provide a pickup of 20 parts per 100 parts of the paper and then dried. Each of the thus treated bases were continuously impregnated with either the above-prepared side chain-double bond type resin solution, an unsaturated polyester resin solution ("Rigolac 155 BQT", a trade name of Showa Highpolymer Co., Ltd.), or an epoxy resin solution (a 90:10:24 (by weight) mixture of Epikote 827/Epikote 154/isophoronediamine). Each of the above resin solutions contained as curing catalysts 1.5 parts by weight of Nyper B and 1.0 parts by weight of Perbuty Z (both, trade names of Nippon Oil & Fat Co.) per 100 parts by weight of the resin solution. The impregnation method and pickup for each of the samples is shown in Table 1 (the pickup being expressed in terms of the total basis weight of the 8 resin-impregnated bases). In some samples, a 35 µm-thick electrolytic copper foil coated on one side thereof with an epoxy resin adhesive (a 70:30 (by weight) mixture of Epikote 827/Versamid (a trade name of Hennkel-Hakusuisha Co.)) was laminated on the resin-impregnated base as an outermost layer. The 8 resin-impregnated bases, some of which included the copper foil, were continuously press-molded at a temperature of 100°C for 5 minutes using a pressurizing medium-containing double belt press as shown in Fig. 1 and then postcured at 120°C for 1 hour to obtain a laminated sheet or a copper-clad (single side) laminated sheet.

The mechanical strength of each of the resulting laminated sheets was measured by a flexural test according to JIS C6481, and the results obtained are shown in Table 1.

In the column "Impregnation Method" of Table 1, "PI-A" means partial impregnation in which the thermosetting resin solution was uniformly impregnated throughout the individual bases to the same extent but not filling all the voids of the base, leaving part of the void volume non-impregnated. The impregnation rate of the base was about 70%. "PI-B" means partial impregnation in which each of 4 of 8 bases was impregnated with the resin solution until all the voilds were completely filled by dip coating and were laminated as interlayers, while the other 4 bases were not impregnated with the resin solution at all and were laminated as outer layers. "CI" means complete impregnation in which all the 8 bases were completely impregnated with the resin solution by dip coating. PI-C" means partial impregnation in which each of 3 of 8 bases were impregnated with the resin solution until all the voids were completely filled and laminated as interlayers, while the other 5 bases were not impreg nated with the resin solution at all, and laminated as outer layers.

The discharged resin amount (Z; %) in Table 1 was calculated from the following equation:

$Z = (X - Y)/[Y - \text{Basis Weight of Base} \times \text{Number of Bases} \times (1 + \text{Pickup Ratio of Treating Agent})] \times 100$

wherein Z is a percentage of the discharged resin amount (%); X is a total basis weight of the 8 resin-impregnated bases (g/$m^2$); and Y is a basis weight of the laminated sheet after release of a copper foil (g/$m^2$). In this example, the above equation becomes:

$Z = (X - Y)/[Y - 135 \times 8 \times (1 + 0.20)]$

TABLE 1

| Sample No. | Impregnating Resin (viscosity: Poise) | Copper Foil | Press Molding Pressure ($kg/cm^2$) | Impregnation Method | X* ($g/m^2$) | Y* ($g/m^2$) | Base Content After Copper Foil Removal (%) | Air Bubbles in Laminated Sheet | Flexural Test strength (Dry) ($kg/mm^2$) | Flexural Test Modulus (100°C) ($kg/mm^2$) | Z* (%) |
|---|---|---|---|---|---|---|---|---|---|---|---|
| Sample 1 of the Present Invention | side chain-double bond type resin (6.2) | not used | 3 | PI-A | 2810 | 2700 | 40 | none observed | 15 | 410 | 8 |
| " 2 | " " | " | 15 | " | 2160 | 2120 | 51 | " | 17 | 500 | 5 |
| " 3 | " " | " | 50 | " | 1870 | 1830 | 59 | " | 20 | 850 | 7 |
| " 4 | " (10) | used | 15 | " | 2240 | 2200 | 49 | " | 17 | 510 | 4 |
| " 5 | " (30) | " | 15 | " | 2220 | 2200 | 49 | " | 17 | 520 | 2 |
| " 6 | " (6.2) | not used | 15 | PI-B | 2340 | 2160 | 50 | " | 17 | 520 | 21 |
| " 7 | unsaturated polyester resin (11) | " | 10 | PI-A | 2500 | 2400 | 45 | " | 16 | 440 | 9 |
| " 8 | epoxy resin (18) | " | 10 | " | 2510 | 2450 | 44 | " | 16 | 500 | 5 |

TABLE 1 (cont'd)

| Sample No. | Impregnating Resin (viscosity: Poise) | Copper Foil | Press Molding Pressure ($kg/cm^2$) | Impreg-nation Method | X* ($g/m^2$) | Y* ($g/m^2$) | Base Content After Copper Foil Removal (%) | Air Bubbles in Laminated Sheet | Flexural Test: strength (Dry) ($kg/mm^2$) | Flexural Test: Modulus (100°C) ($kg/mm^2$) | Z* (%) |
|---|---|---|---|---|---|---|---|---|---|---|---|
| Comparative Sample 1 | side chain-double bond type resin (6.2) | not used | 15 | CI | 3375 | 2160 | 50 | none observed | 17 | 500 | 210 |
| " 2 | " " | " | 15 | PI-C | 2080 | 2070 | 52 | many air bubbles present on the entire surface | 13 | 430 | 1 |
| " 3 | " " | " | 0.5 | PI-A | 3470 | 3270 | 33 | air bubbles present in the entire laminate | 12 | 250 | 11 |
| " 4 | " " | " | 110 | " | 1560 | 1540 | 70 | interlaminar separation occured | - | - | 8 |

Note: *: X, Y, and Z are as defined above.

As can be seen from the results of Table 1, the method of the present invention provides a laminated sheet having a high base content (40 to 50%) while minimizing the amount of the resin solution discharged on pressing by partial impregnation of the thermosetting resin solution into the base. In Comparative Sample 2 in which the resin impregnation was partial, a satisfactory laminated sheet was not be obtained due to insufficient resin pickup by the bases as a whole.

## EXAMPLE 2

### SAMPLES 8 TO 15 AND COMPARATIVE SAMPLES 5 TO 8

Each of 8 sheets of commercially available kraft paper of continuous length (base weight: 135 $g/m^2$; density: 0.49 $g/cm^3$) was impregnated with N-methylolmelamaine ("Nicaresin S-305") so as to have a pickup of 20 parts per 100 parts of the paper and then dried. Each of the thus treated bases was continuously impregnated with either the above-prepared side chain-double bond type resin solution, an unsaturated polyester resin solution ("Rigolac 155 BQT"), or an epoxy resin solution [Epikote 728/Epilote 154/isophoronediamine (90:10:24)]. Each of the above resin solutions contained curing catalysts as in Example 1. The impregnation method and pickup for each of the samples is shown in Table 2 (the pickup being expressed in terms of the total bases weight of the 8 resin-impregnated bases). In some samples, a 35 µm-thick electrolytic copper foil coated on one side thereof with an epoxy resin adhesive used in Example 1 was laminated on the resin-impregnated base as an outermost layer. The 8 resin-impregnated bases, some of which included the copper foil, were continuously press molded at a temperature of 100 °C for 5 minutes using a pressurizing medium-containing double belt press as shown in Fig. 4 and then postcured at 120 °C for 1 hour to obtain a laminated sheet or a copper-clad (single side) laminated sheet. The results obtained are shown in Table 2.

In the column "Impregnation Method" of Table 2, "PI-D" means partial impregnation in which the thermosetting resin solution was impregnated into each of the 8 bases to the same extent throughout the central portion but not to the full width of the base, leaving both edges of the base non-impregnated. Such partial impregnation could be achieved by the use of a slit nozzel type applicator. "PI-E" means partial impregnation in which the central portions of each of the 8 bases were impregnated with the resin solution until all the voids in the central portions were completely filled with the resin solution, while both edges of the base remained non-impregnated. Such partial impregnation was achieved by folding the base so as to provide a U-shaped section during impregnation. "CP" means complete impregnation in which all the 8 bases were completely impregnated with the resin solution by dipping. In either "PI-D" or "PI-E", the resin solution was impregnated to a width of 1030 mm of the total 1070 mm, width of the paper base.

TABLE 2

| Sample No. | Impregnating Resin (viscosity: Poise) | Copper Foil | Press Molding Pressure (kg/cm$^2$) | Impregnation Method | X* (g/m$^2$) | Y* (g/m$^2$) | Base Content After Copper Foil Removal (%) | Air Bubbles in Laminated Sheet | Flexural Test strength (Dry) (kg/mm$^2$) | Flexural Test Modulus (100°C) (kg/mm$^2$) | Z'** (%) |
|---|---|---|---|---|---|---|---|---|---|---|---|
| Sample 8 of the Present Invention | side chain-double bond type resin (6.2) | not used | 3 | PI-D | 2740 | 2640 | 38 | none observed | 14.5 | 395 | 1.0 |
| " 9 | " " | " | 15 | " | 2185 | 2145 | 51 | " | 17.0 | 500 | 1.5 |
| " 10 | " " | " | 50 | " | 1935 | 1810 | 60 | " | 20.5 | 875 | 2.5 |
| " 11 | " (10) | used | 15 | " | 2320 | 2195 | 50 | " | 17.5 | 525 | 1.5 |
| " 12 | " (30) | " | 15 | " | 2215 | 2175 | 48 | " | 16.5 | 520 | 1.0 |
| " 13 | " (6.2) | not used | 15 | PI-E | 2405 | 2170 | 51 | " | 17.0 | 530 | 6.0 |
| " 14 | unsaturated polyester resin (11) | " | 10 | PI-D | 2570 | 2355 | 46 | " | 16.0 | 450 | 2.0 |
| " 15 | epoxy resin (18) | " | 10 | " | 2570 | 2465 | 44 | " | 16.0 | 505 | 2.5 |

TABLE 2 (cont'd)

| Sample No. | Impregnating Resin (viscosity: Poise) | Copper Foil | Press Molding Pressure ($kg/cm^2$) | Impregnation Method | X* ($g/m^2$) | Y* ($g/m^2$) | Base Content After Copper Foil Removal (%) | Air Bubbles in Laminated Sheet | Flexural Test strength (Dry) ($kg/mm^2$) | Flexural Test Modulus (100°C) ($kg/mm^2$) | Z'** (%) |
|---|---|---|---|---|---|---|---|---|---|---|---|
| Comparative Sample 5 | side chain-double bond type resin (6.2) | not used | 15 | CI | 3485 | 2160 | 51 | none observed | 17.0 | 510 | 210 |
| " 6 | " " | " | 15 | PI-D | 2075 | 2080 | 51 | many air bubbles present on the entire surface | 12.5 | 425 | 0.5 |
| " 7 | " " | " | 0.5 | " | 3410 | 3225 | 32 | air bubbles present in the entire laminate | 11.5 | 240 | 2.0 |
| " 8 | " " | " | 110 | " | 1645 | 1665 | 63 | interlaminar separation occured | - | - | 5.0 |

Note: *: X and Y are as defined above.

**: Z' is the percentage of the amount of the resin discharged on pressing out of the central resin-impregnated portion.

As is apparent from the Table 2, the method of the present invention provides a laminated sheet having a high base content while minimizing the amount of the resin solution being discharged on pressing by partially impregnating the resin solution into the base.

On the contrary, in Comparative Sample 5, the discharged resin was not absorbed into the non-impregnated portion of the base. Comparative Sample 6, in which partial impregnation was conducted, was defective insufficient resin pickup by the bases as whole. Comparative Sample 7 did not achieve sufficient impregnation due to insufficient application of pressure. Comparative Sample 8, in which an excessive amount of pressure was applied, induced interlaminar separation due to excessive loss of the resin solution. Each Comparative sample was defective.

## EXAMPLE 3

### SAMPLES 16 TO 22 AND COMPARATIVE SAMPLES 9 TO 12

Each of 8 sheets of commercially available kraft paper of continuous length (base weight: 135 $g/m^2$; density: 0.49 $g/cm^3$) was impregnated with N-methylolmelamaine ("Nicaresin S-305") so as to provide a pickup of 20 parts per 100 parts of the paper and was then dried. Each of the thus treated bases was continuously impregnated with either the above-prepared side chain-double bond type resin solution, an unsaturated polyester resin solution ("Rigolac 155 BQT"), or an epoxy resin solution [Epikote 827/Epilote 154/isophoronediamine (90:10:2)]. Each of the above resin solutions contained curing catalysts as in Example 1. The 8 resin-impregnated bases were then introduced between press rolls in laminated form to squeeze out excess resin solution to provide a resin pickup as shown in Table 3 (the pickup was expressed in terms of the total bases weight of the 8 impregnated bases after squeezing). In some cases, a 35 µm-thick electrolytic copper foil coated on one side thereof with an epoxy resin adhesive used in Examdple 1 was laminated on the resin-impregnated base as an outermost layer.

Thereafter, the base laminates, same of which included the copper foil, were continuously heat-pressed at 100 °C for 5 minutes under a pressure of from 3 to 50 $kg/cm^2$ by means of a double belt press to obtain a laminated sheet or copper-clad (single side) laminated sheet. The resulting laminated sheet was cut to size, and a number of the cut-to-size sheets were stacked and postcured at 120 °C for 1 hour.

For comparison, a laminated sheet was produced in the same manner as described above, except that the resin-impregnated bases were laminated and heat-pressed without passing through the squeeze rolls for removal of excess resin solution (Comparative Sample 9), or except for varying the applied pressure in the double belt press (Comparative Samples 10 to 12).

The results obtained are shown in Table 3. In Table 3, the amount of the resin discharged on pressing ($Z''$; %) was calculated from the following equation:

$Z'' = (X' - Y)/[Y - \text{Basis Weight of Untreated Base} \times \text{Number of Bases} \times (1 + \text{Pickup Ratio of Treating Agent})] \times 100$

wherein $Z''$ is a percentage of the discharged resin amount (%); $X'$ is a total basis weight of the 8 resin-impregnated bases after squeezing ($g/m^2$); and Y is a basis weight of the laminated sheet after release of a copper foil ($g/m^2$). In this example, the above equation becomes:

$Z'' = (X' - Y)/[Y - 135 \times 8 \times (1 + 0.20)]$

TABLE 3

| Sample No. | Impregnating Resin (Viscosity: Poise) | Copper Foil | Press Molding Pressure ($kg/cm^2$) | X* ($g/m^2$) | Y* ($g/m^2$) | Base Content After Copper Foil Removal (%) | Air Bubbles in Laminated Sheet | Flexural Test strength (Dry) ($kg/mm^2$) | Flexural Test Modulus (100°C) ($kg/mm^2$) | Z"* (%) |
|---|---|---|---|---|---|---|---|---|---|---|
| Sample 16 of the Present Invention | side chain-double bond type resin (6.2) | not used | 3 | 2800 | 2700 | 40 | none observed | 15 | 400 | 7 |
| " 17 | " " | " | 15 | 2190 | 2160 | 50 | " | 17 | 520 | 4 |
| " 18 | " " | " | 50 | 1900 | 1860 | 58 | " | 19 | 800 | 7 |
| " 19 | unsaturated polyester resin (11) | " | 10 | 2490 | 2400 | 45 | " | 16 | 450 | 8 |
| " 20 | epoxy resin ( 18) | " | 10 | 2510 | 2450 | 44 | " | 16 | 500 | 6 |
| " 21 | side chain-double bond type resin (10) | used | 15 | 2280 | 2250 | 48 | " | 17 | 500 | 3 |
| " 22 | " (30) | " | 15 | 2290 | 2250 | 48 | " | 17 | 510 | 4 |

TABLE 3 (cont'd)

| Sample No. | Impregnating Resin (Viscosity: Poise) | Copper Foil | Press Molding Pressure ($kg/cm^2$) | X* ($g/m^2$) | Y* ($g/m^2$) | Base Content After Copper Foil Removal (%) | Air Bubbles in Laminated Sheet | Flexural Test: strength (Dry) ($kg/mm^2$) | Flexural Test: Modulus (100°C) ($kg/mm^2$) | Z"* (%) |
|---|---|---|---|---|---|---|---|---|---|---|
| Comparative Sample 9 | side chain-double bond type resin (6.2) | not used | 15 | 3375 (not squeezed) | 2160 | 50 | non observed | 17 | 500 | 210 |
| " 10 | " | " | 15 | 2160 | 2150 | 51 | many air bubbles present at both edges | 14 | 450 | 1 |
| " 11 | " | " | 0.5 | 3470 | 3270 | 33 | air bubbles present in the entire laminate | 12 | 250 | 11 |
| " 12 | " | " | 110 | 1680 | 1660 | 65 | interlaminar separation occured | - | - | 6 |

Note: *: X, Y, and Z" are as defined above.

The results of Table 3 demonstrate that the method of the present invention provides a laminated sheet containing no observable air bubbles and having good mechanical strength, particularly flexural strength, while minimizing the amount of the resin solution discharged on pressing.

## EXAMPLE 4

### SAMPLES 23 TO 30 AND COMPARATIVE SAMPLES 13 TO 16

Each of 8 sheets of commercially available kraft paper of continuous length (base weight: 135 $g/m^2$; density: 0.49 $g/cm^3$) were impregnated with N-methylolmelamaine ("Nicaresin S-305") so as to provide a pickup of 20 parts per 100 parts of the paper and were then dried. Each of the thus treated bases were continuously impregnated with either the above-prepared side chain-double bond type resin solution, an unsaturated polyester resin solution ("Rigolac 155 BQT"), or an epoxy resin solution [Epikote 827/Epilote 154/isophoronediamine (90:10:24)]. Each of these resin solutions contained curing catalysts as used in Examdple 1. The impregnation method and pickup for each of the samples is shown in Table 4 (the pickup being expressed in terms of the total basis weight of the 8 resin-impregnated bases). In some samples, a 35 µm-thick electrolytic copper foil coated on one side thereof with an epoxy resin adhesive used in Example 1 was laminated on the resin-impregnated base as an outermost layer. The 8 resin-impregnated bases, some of which included the copper foil, were continuously press molded at 100 °C for 5 minutes under the applied pressure shown in Table 4 using a pressurizing medium-containing double belt press as shown in Fig. 7 and then postcured at 120 °C for 1 hour to obtain a laminated sheet or a copper-clad (single side) laminated sheet. The results obtained are shown in Table 4.

In the column "Impregnation Method" of Table 4, "PI-F" means partial impregnation in which each of the 8 bases were impregnated with the resin solution by dipping and then passed through a pair of squeeze rolls to adjust the resin pickup. "PI-G" means partial impregnation in which each of the 8 bases were impregnated to the central portion thereof to the same degree throughout the base but not to the edge portions. Such partial impregnation can be achieved by the use of a slit nozzel type applicator. "CI" means complete impregnation in which each of the 8 bases were completely impregnated with the resin solution by dipping. For each sample, the width of the paper base was 1070 mm.

Z‴ in Table 4 means the percentage of the resin solution discharged on pressing from the edges of the resin-impregnated bases, not including the resin solution discharged which flows downward.

As is apparent from the results of Table 4, a laminated sheet having a high base content is provided by the present invention while minimizing the discharge of the resin solution on pressing to extremely low levels by using the upright double belt press.

Comparative Sample 13 also provided a satisfactory laminated sheet, but the amount of the discharged resin was so great that the resin overflowed from the machine. In Comparative Sample 14, the impregnation was partial, but the pickup of the resin was insufficient to form an acceptable laminate. In Comparative Sample 15, the impregnation was insufficient due to insufficient applied pressure in the heat-pressing step. In Comparative Sample 16, the pressure applied in the heat-pressing step was excessive leading to excessive loss of the resin solution from the laminate, and, as a result, the laminated sheet delaminated.

TABLE 4

| Sample No. | Impregnating Resin (Viscosity: Poise) | Copper Foil | Press Molding Pressure ($kg/cm^2$) | Impregnation Method | X* ($g/m^2$) | Y* ($g/m^2$) | Base Content After Copper Foil Removal (%) | Air Bubbles in Laminated Sheet | Flexural Test strength (Dry) ($kg/mm^2$) | Flexural Test Modulus (100°C) ($kg/mm^2$) | Z'''* (%) |
|---|---|---|---|---|---|---|---|---|---|---|---|
| Sample 23 of the Present Invention | side chain-double bond type resin (6.2) | not used | 3 | PI-F | 2695 | 2650 | 38 | none observed | 14.6 | 390 | 2.0 |
| " 24 | " " | " | 15 | " | 2190 | 2130 | 51 | " | 16.8 | 505 | 2.4 |
| " 25 | " " | " | 50 | " | 1965 | 1800 | 60 | " | 20.8 | 860 | 3.2 |
| " 26 | " (10) | used | 15 | " | 2355 | 2175 | 50 | " | 17.8 | 530 | 2.6 |
| " 27 | " (30) | " | 15 | " | 2205 | 2175 | 48 | " | 16.3 | 515 | 2.0 |
| " 28 | " (6.2) | not used | 15 | PI-G | 2430 | 2140 | 51 | " | 16.7 | 540 | 5.0 |
| " 29 | unsaturated polyester resin (11) | " | 10 | PI-F | 2600 | 2355 | 46 | " | 16.1 | 445 | 2.8 |
| " 30 | epoxy resin (18) | " | 15 | " | 2595 | 2460 | 44 | " | 15.9 | 500 | 3.2 |

TABLE 4 (cont'd)

| Sample No. | Impregnating Resin (viscosity: Poise) | Copper Foil | Press Molding Pressure (kg/cm$^2$) | Impregnation Method | X* (g/m$^2$) | Y* (g/m$^2$) | Base Content After Copper Foil Removal (%) | Air Bubbles in Laminated Sheet | Flexural Test strength (Dry) (kg/mm$^2$) | Flexural Test Modulus (100°C) (kg/mm$^2$) | Z'''* (%) |
|---|---|---|---|---|---|---|---|---|---|---|---|
| Comparative Sample 13 | side chain-double bond type resin (6.2) | not used | 15 | CI | 3535 | 2160 | 51 | none observed | 16.7 | 515 | 30** |
| " 14 | " " | " | 15 | PI-F | 2065 | 2060 | 51 | many air bubbles present on the entire surface | 12.5 | 430 | 1.4 |
| " 15 | " " | " | 0.5 | " | 3370 | 3220 | 32 | air bubbles present in the entire laminate | 11.6 | 240 | 2.8 |
| " 16 | " " | " | 110 | " | 1625 | 1635 | 63 | interlaminar separation occured | - | - | 4.5 |

Note: *: X, Y, and Z''' are as defined above.

**: Discharged resin overflowed from the machine.

## EXAMPLE 5

### SAMPLES 31 TO 36 AND COMPARATIVE SAMPLES 17 TO 18

In the same manner as in Impregnation Method PI-G in Example 4, each of 6 sheets of 270 µm-thick kraft paper of continuous length were partially impregnated with the resin solution shown in Table 5 which contained curing catalysts as in Example 1. The 6 resin-impregnated bases were introduced into a double belt press and heat pressed at 100 °C under the pressure shown in Table 5, at a running speed of 0.5 m/min, using an apparatus containing, as a pressurizing and heating means, a pair of pressurizing chambers each containing a pressurizing fluid as shown in Fig. 1, to obtain a laminated sheet. The effective heat-pressing zone of the double belt press was 1 m long and 0.5 m wide. In Sample 36, a copper-clad laminated sheet was produced in the same manner as described above, except for further laminating a 35 µm-thick electrolytic copper foil coated on one side thereof an epoxy resin adhesive used in Example 1 on the resin-impregnated base as an outermost layer and heat-pressed by using the apparatus of Fig. 2.

For comparison, a copper-clad laminated sheet was produced in the same manner as in Sample 36, except for using a double belt press containing, as a heat pressing means, five pairs of press roll each having a diameter of 20 cm and a width of 70 cm placed at spacings of 50 cm (Comparative Sample 17) or using a double belt press containing, as a heat pressing means, a pair of metallic press plates having an effective pressurizing zone of 1 m long and 0.5 m wide (Comparative Sample 18).

In each double belt press used to process Samples 31 to 36 and Comparative Samples 17 and 18, endless belts having a standard thickness of 1.00 mm and a thickness tolerance of ±60 µm were used.

Each of the resulting laminated sheets was evaluated for average thickness, wrinkles of the copper foil, if used, interlaminar separation, incorporation of air, and variation of thickness. The results obtained are shown in Table 5.

TABLE 5

| Sample No. | Impregnating Solution [Viscosity (20°C): poise] | Copper Foil | Press Molding Pressure ($kg/cm^2G$) | Avg. Thickness of Laminate (mm) | Wrinkle of Copper Foil | Interlaminar Separation or Air Incorporation | Thickness Variation of Laminate (μm) |
|---|---|---|---|---|---|---|---|
| Sample 31 of the Present Invention | vinyl ester resin "Ripoxy H 610" made by Showa High-polymer Co., Ltd. [0.3] | not used | 5 | 1.610 | - | none observed | ±25 |
| " 32 | vinyl ester resin "Ripoxy R 806" made by Showa High-polymer Co., Ltd. [1] | " | 10 | 1.605 | - | " | ±30 |
| " 33 | unsaturated polyester resin " 155 BQT" made by Showa Highpolymer Co., Ltd. [11] | " | 15 | 1.590 | - | " | ±25 |
| " 34 | unsaturated polyester resin "FMS-583" made by Nippon Yupika K.K. [30] | " | 35 | 1.570 | - | " | ±30 |
| " 35 | side chain-double bond type resin consisting mainly of a component having a side chain of foumula (I) [10] | " | 15 | 1.615 | - | " | ±20 |
| " 36 | " " | used | 15 | 1.680 | none observed | " | ±25 |

TABLE 5 (cont'd)

| Sample No. | Impregnating Solution [Viscosity (20°C): poise] | Copper Foil | Press Molding Pressure ($kg/cm^2G$) | Avg. Thickness of Laminate (mm) | Wrinkle of Copper Foil | Interlaminar Separation or Air Incorporation | Thickness Variation of Laminate (μm) |
|---|---|---|---|---|---|---|---|
| Comparative Sample 17 | side chain-double bond type resin consisting mainly of a component having a side chain of foumula (I) [10] | used | 10* | 1.670 | wrinkles present | present | ±80 |
| " 18 | " " | " | 15 | 1.685 | none observed | none observed | ±75 |

Note: *: The maximum planar pressure as measured by means of a film type manometer.

As is seen from the results of Table 5, delamination or the incorporation of air was not seen in any of the laminated sheets obtained in Samples 31 to 36 of the present invention. Moreover, the samples of the present invention had a narrower variation in laminate thickness as compared to the comparative samples, thus further demonstrating the superior results obtained using the method of the present invention.

While the invention has been described in detail and with reference to specific embodiments thereof, it will be apparent to one skilled in the art that various changes and modifications can be made therein without departing from the spirit and scope thereof.

## Claims

1. A method for continuously producing a laminated sheet comprising the steps of impregnating a fibrous base of continuous length with a thermosetting resin solution which neither essentially requires a drying step nor essentially produces reaction by-products during the curing reaction thereof, layering a plurality of the impregnated bases and heat-pressing to cure the resin solution to provide an integral structure, wherein said impregnating step is carried out by partially impregnating the base with the resin solution and said heat-pressing step is carried out in such a manner that the resin solution penetrates throughout the layered bases by using a double belt press comprising endless belts, said press applying a substantially even pressure over the entire pressurizing zone.

2. A method as claimed in claim 1, wherein said partial impregnation is carried out such that the plurality of the bases has the same extent of impregnation and wherein a portion of the voids of each base are impregnated.

3. A method as claimed in claim 1, wherein said partial impregnation is carried out such that the central portion of each of the plurality of bases in the widthwise direction has a higher pickup of the resin solution than the both edge portions of said central portion.

4. A method as claimed in claim 1, wherein said partial impregnation is carried out such that of from 1 to 5% based on the total area in the widthwise direction of the both edge portions of the plurality of bases remain non-impregnated, and the central portions between the both edges are impregnated with the resin solution in a substantially uniform manner in the widthwise direction.

5. A method as claimed in claim 1, wherein said partial impregnation is carried out such that at least one base which is to be positioned in the central portion of the laminated sheet in the depthwise direction has a higher pickup of the resin solution than at least two bases each of which is layered on opposing sides of said base positioned in the central portion.

6. A method as claimed in claim 1, wherein said partial impregnation comprises impregnating the resin solution into each of the plurality of bases to fill substantially all the voids therein and then removing the resin solution from the resin-impregnated bases or a laminate thereof to such a degree that each of the impregnated bases contains voids in the absence of applied pressure.

7. A method as claimed in claim 1, wherein said heat-pressing step is carried out in such a manner that a laminate of the resin-impregnated bases is heat pressed to continuously semi-cure the resin solution to such a degree that the base no longer undergoes elastic restortion while allowing the partially impregnating resin solution to penetrate throughout the whole laminate and then continuously postcuring the resin by heating in the absence of applied pressure.

8. A method as claimed in claim 1, wherein said laminated sheet is a metal-clad laminated sheet in which a metal foil is layered on at least one side of a laminate of the plurality of bases simultaneously with or separately from the layering up of the bases.

9. A method as claimed in claim 6, wherein said method further includes layering a metal foil on at least one side of a laminate of the plurality of bases after the removal of the impregnating resin from the resin-impregnated bases.

10. A method as claimed in claim 1, wherein said double belt press contains a pair of pressurizing chambers each containing a fluid as a pressurizing medium, each of said endless belts constituting one side of each of said pressurizing chambers.

11. A method as claimed in claim 1, wherein said heat pressing is at a pressure of from 1 to 100 $kg/cm^2$.

12. A method as claimed in claim 1, wherein said base is paper.

13. A method as claimed in claim 1, wherein the resin solution is impregnated into each of the plurality of bases substantially uniformly in the widthwise direction, and the apparatus of said heat pressing step is positioned substantially vertically to the operating line of said impregnation step.

14. A method for continuously producing a laminated sheet comprising impregnating a fibrous base of continuous length with a thermosetting resin solution which neither essentially requires a drying step nor essentially produces reaction by-products during the curing thereof, layering a plurality of the resin-impregnated bases and heat-pressing to cure the resin solution to provide an integral structure, wherein said heat pressing step is positioned substantially vertically to the operating line of said impregnation step and said step of heat pressing is carried out in such a manner that the plurality of the resin-impregnated bases are heat-pressed using a double belt press comprising two endless belts, sa.i.d press applying a substantially even pressure over the entire pressurizing zone to penetrate the impregnating resin solution throughout the bases while discharging excess resin solution from the bases, said discharged resin flowing downward by gravity.

15. A method as claimed in claim 14, wherein said laminated sheet is a metal-clad laminated sheet in which a metal foil is layered on at least one side of a laminate of the plurality of bases simultaneously with or separately from the layering up of the bases.

16. A method as claimed in claim 14, wherein said double belt press comprises a pair of pressurizing chambers each containing a fluid as a pressurizing medium, each of said endless belts constituting one side of each of said pressurizing chambers.

17. A method as claimed in claim 14, wherein said heat pressing is at a pressure of from 1 to 100 $kg/cm^2$.

18. A method as claimed in claim 14, wherein said base is paper.

19. A method for continuously producing a laminated sheet comprising impregnating a fibrous base of continuous length with a resin solution, layering a plurality of the resin impregnated bases and heat-pressing the resin-impregnated bases in a double belt press comprising two endless belts to cure the resin solution to provide an integral structure, said layering step being optionally carried out in said heat-pressing step and wherein said heat-pressing step is carried out by charging a fluid as a pressurizing and heating medium into each pair of pressurizing chambers under pressure, each of said endless constituting one side of each of said pressurizing chambers.

20. A method for continuously producing a laminated sheet comprising impregnating a resin solution into a fibrous base of continuous length, layering a plurality of the resin-impregnated bases and at least one metal foil simultaneously or successively such that the metal foil constitutes the outermost layer, and heat-pressing the laminate of the bases by using a double belt press comprising two endless belts to unite the laminate into a body, wherein said heat-pressing step is carried out by charging a fluid as a pressurizing and heating medium into each pair of pressurizing chambers, each of said endless belts constituting one side of each of said pressurizing chambers.

21. An apparatus for continuously producing a laminated sheet comprising a letoff gear for feeding a plurality of fibrous bases of continuous lengths, an impregnation machine for impregnating each of the bases with a resin solution, and a double belt press comprising two endless belts, said letoff gear, impregnation machine, and double belt press being connected in series, and wherein a pair of pressurizing chambers each containing a fluid as a pressurizing and heating medium are provided where each of the endless belts of said double belt press and the resin-impregnated base are in contact, each of said endless belts constituting one side of each of said pressurizing chambers.

Neu eingereicht / Newly filed
Nouvellement déposé

FIG.1

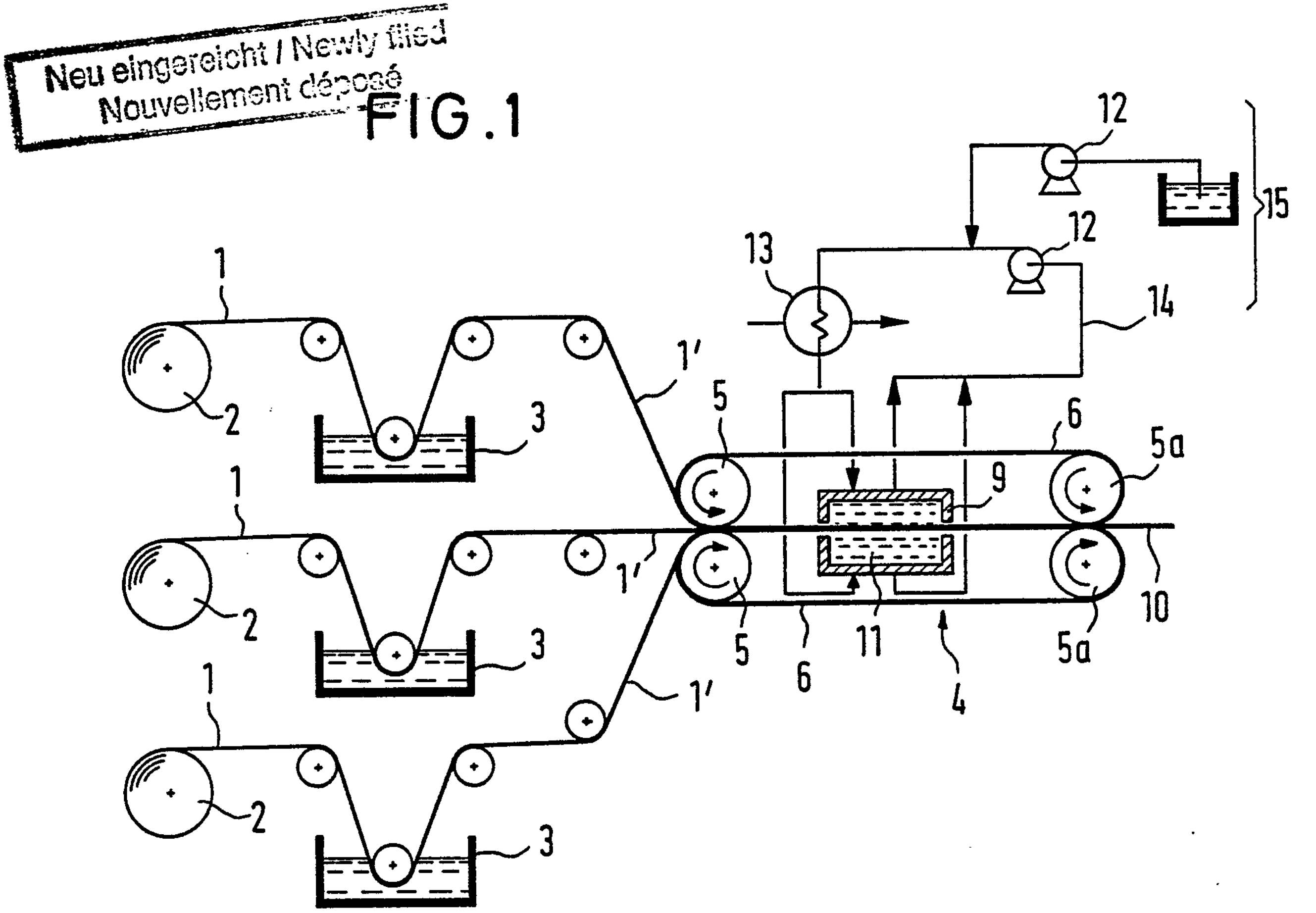


FIG.2

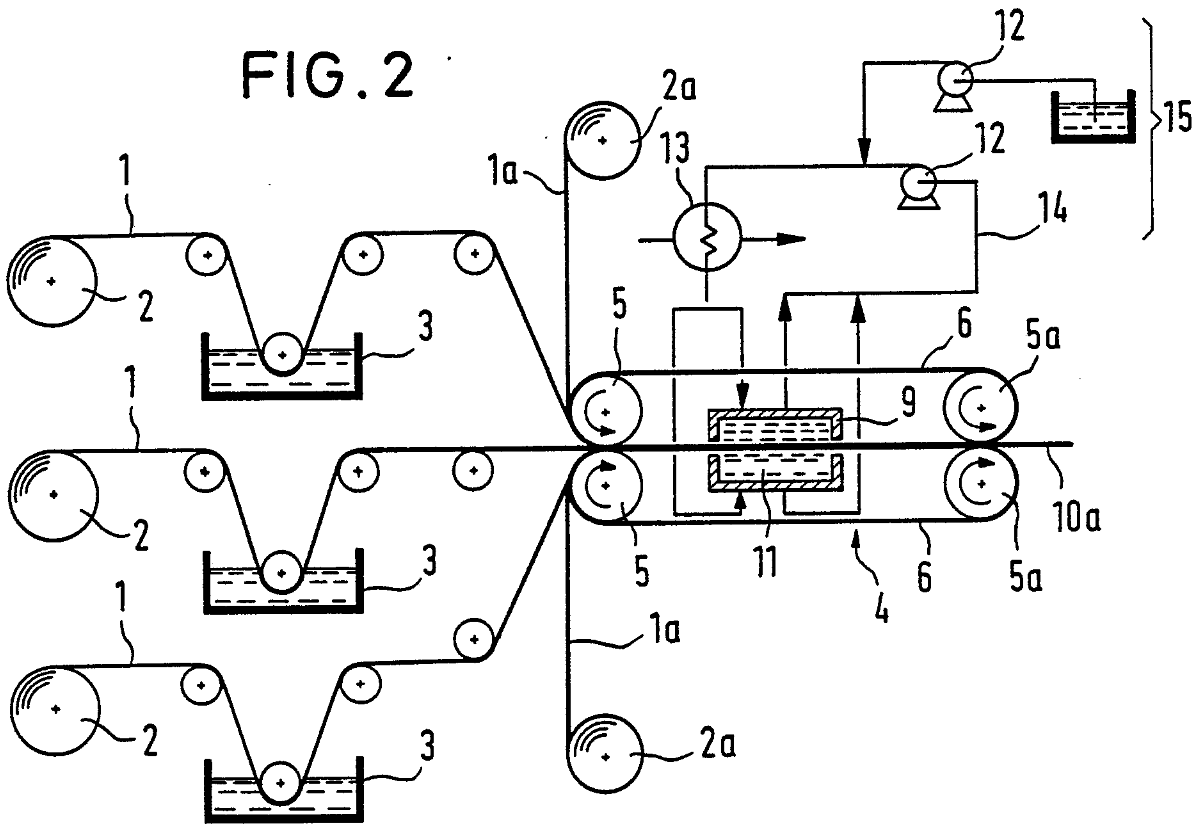

12.07.89

Neu eingereicht / Newly filed
Nouvellement déposé

FIG.3

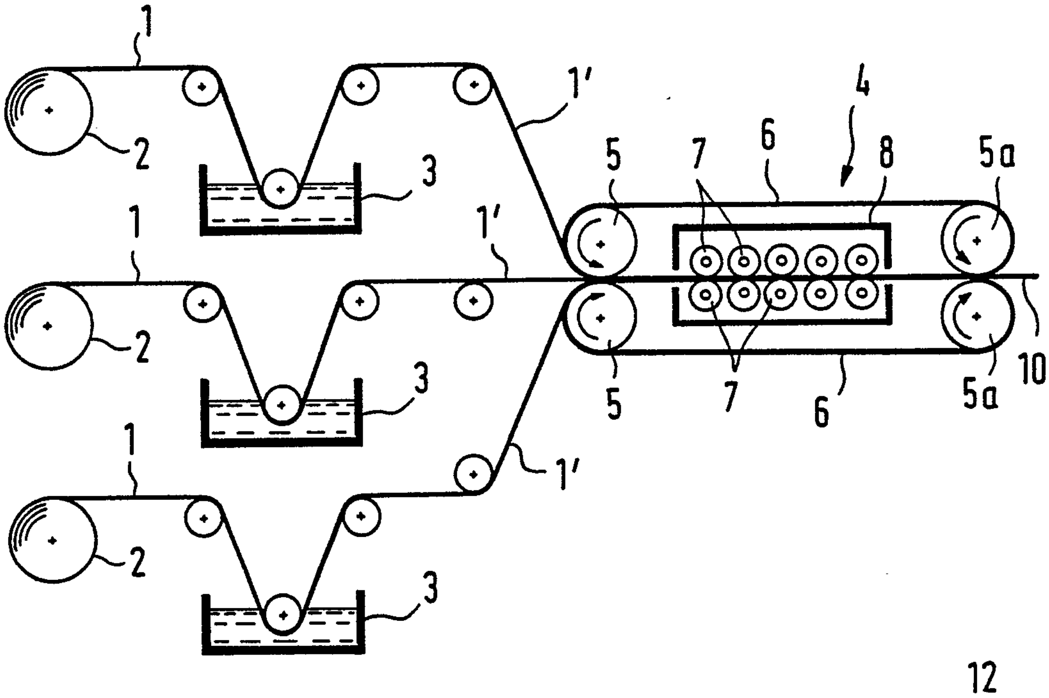


FIG.4

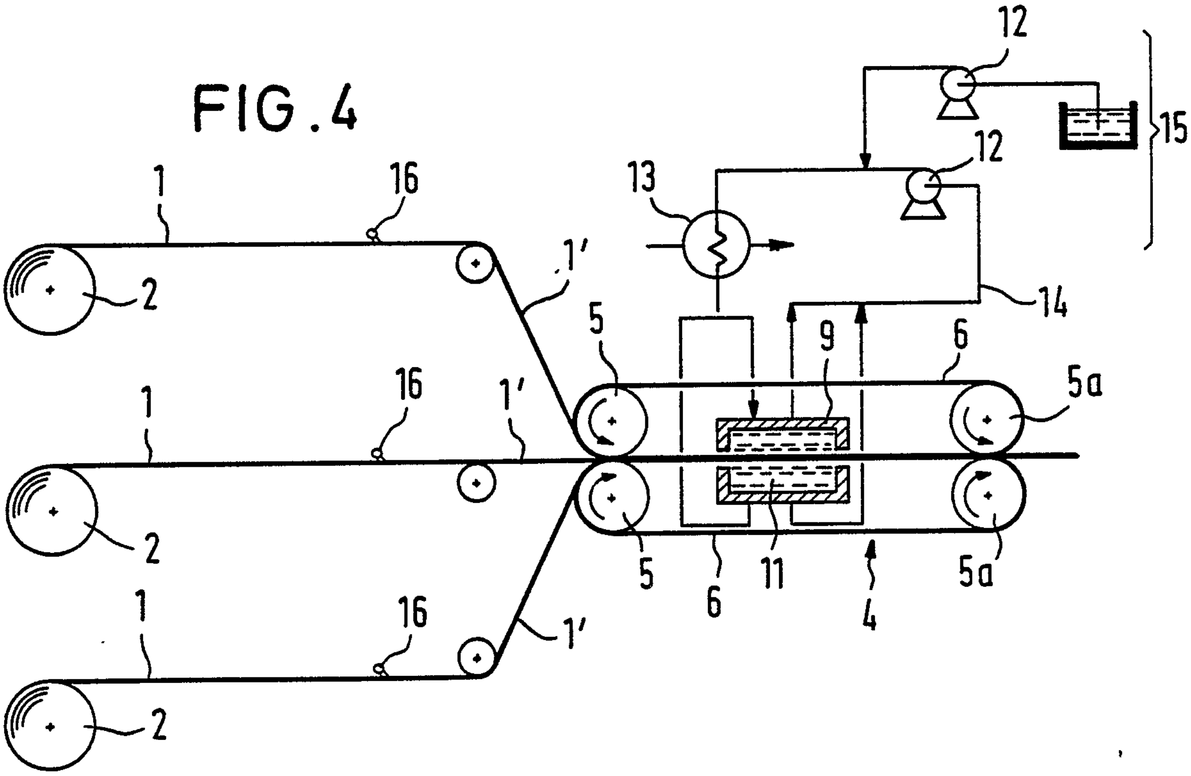


FIG.5

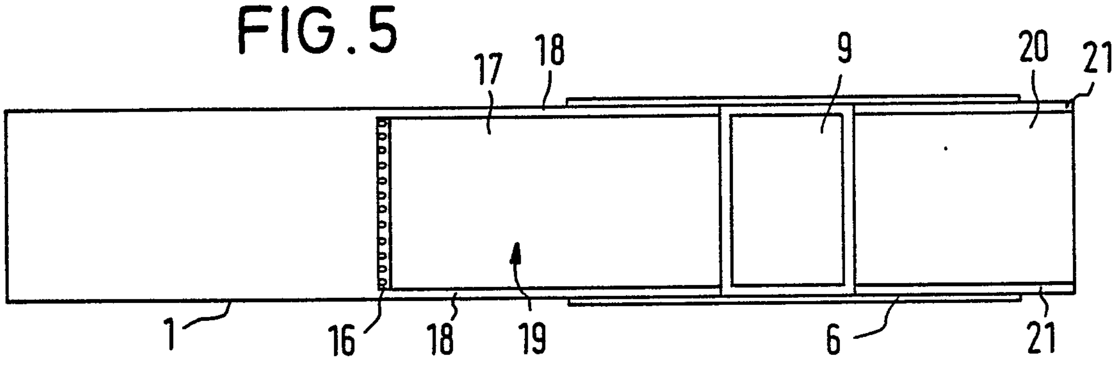

12·07·89

Neu eingereicht / Newly fil
Nouvellement déposé

FIG. 6

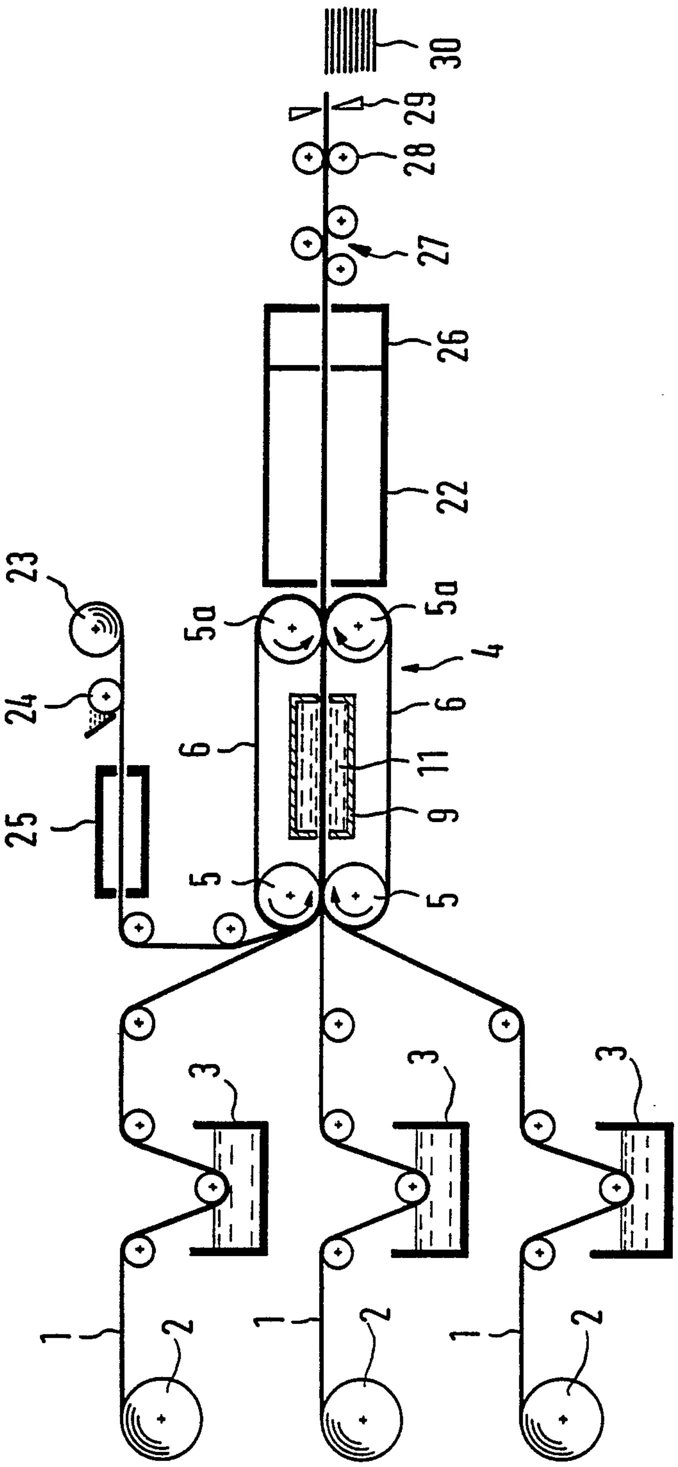

Neu eingereicht / Newly filed
Nouvellement déposé

FIG.7